(19) Europäisches Patentamt
European Patent Office
Office européen des brevets

(11) EP 3 715 393 B1

(12) # EUROPEAN PATENT SPECIFICATION

(45) Date of publication and mention of the grant of the patent:
**08.03.2023 Bulletin 2023/10**

(21) Application number: **18896961.2**

(22) Date of filing: **18.12.2018**

(51) International Patent Classification (IPC):
***C08F 290/06*** (2006.01) ***B32B 27/00*** (2006.01)
***C08J 5/24*** (2006.01) ***H05K 1/03*** (2006.01)
***C08G 65/48*** (2006.01)

(52) Cooperative Patent Classification (CPC):
(C-Sets available)
**H05K 1/0353; B32B 5/022; B32B 15/12; B32B 15/14; B32B 15/20; C08F 290/06; C08F 290/062; C08J 5/244; C08J 5/249;**
B32B 2260/021; B32B 2260/028; B32B 2260/046; B32B 2262/0269; B32B 2262/0276; B32B 2262/101; (Cont.)

(86) International application number:
**PCT/JP2018/046471**

(87) International publication number:
**WO 2019/131306 (04.07.2019 Gazette 2019/27)**

(54) **RESIN COMPOSITION, PREPREG, RESIN-INCLUDING FILM, RESIN-INCLUDING METAL FOIL, METAL-CLAD LAMINATE, AND WIRING BOARD**

HARZZUSAMMENSETZUNG, PREPREG, HARZ ENTHALTENDER FILM, HARZ ENTHALTENDE METALLFOLIE, METALLKASCHIERTES LAMINAT UND LEITERPLATTE

COMPOSITION DE RÉSINE, PRÉ-IMPRÉGNÉ, FILM COMPRENANT DE LA RÉSINE, FEUILLE MÉTALLIQUE COMPRENANT DE LA RÉSINE, STRATIFIÉ À REVÊTEMENT MÉTALLIQUE, ET TABLEAU DE CONNEXIONS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.12.2017 JP 2017253159**

(43) Date of publication of application:
**30.09.2020 Bulletin 2020/40**

(73) Proprietor: **Panasonic Intellectual Property Management Co., Ltd.**
**Osaka-shi, Osaka 540-6207 (JP)**

(72) Inventors:
- **TOSHIMITSU, Kenichi**
**Osaka-shi, Osaka 540-6207 (JP)**
- **NAKAMURA, Yoshihiko**
**Osaka-shi, Osaka 540-6207 (JP)**
- **FUJISAWA, Hiroyuki**
**Osaka-shi, Osaka 540-6207 (JP)**
- **TUMURAYA, Yuuji**
**Osaka-shi, Osaka 540-6207 (JP)**
- **YAMAUCHI, Akihiro**
**Osaka-shi, Osaka 540-6207 (JP)**
- **SHINPO, Takashi**
**Osaka-shi, Osaka 540-6207 (JP)**

(74) Representative: **Appelt, Christian W.**
**Boehmert & Boehmert**
**Anwaltspartnerschaft mbB**
**Pettenkoferstrasse 22**
**80336 München (DE)**

(56) References cited:
**EP-A1- 1 997 840**
**WO-A1-2015/064064**
**WO-A1-2016/072404**
**WO-A1-2017/006891**
**WO-A1-2017/170551**
**WO-A1-2018/159080**
**JP-A- 2009 001 783**
**JP-A- 2017 137 492**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**US-A1- 2017 166 729**

(52) Cooperative Patent Classification (CPC): (Cont.)
B32B 2307/206; B32B 2457/08; C08J 2371/12;
H05K 1/0366

C-Sets
**C08F 290/06, C08F 222/102, C08F 226/10;**
**C08F 290/062, C08F 222/102, C08F 226/10**

## Description

### Technical Field

The present invention relates to a resin composition, a prepreg, a film with resin, a metal foil with resin, a metal-clad laminate, and a wiring board.

### Background Art

As the information processing quantity by various kinds of electronic equipment increases, mounting technologies such as high integration of semiconductor devices to be mounted, densification of wiring, and multi-layering are progressing. In addition, wiring boards to be used in various kinds of electronic equipment are required to be, for example, high-frequency compatible wiring boards such as a millimeter-wave radar board for in-vehicle use. Substrate materials for forming substrates of wiring boards to be used in various kinds of electronic equipment are required to have a low dielectric constant and a low dielectric loss tangent in order to increase the signal transmission speed and to decrease the signal transmission loss.

It is known that polyphenylene ether exhibits excellent low dielectric properties such as a low dielectric constant and a low dielectric loss tangent and exhibits excellent low dielectric properties such as a low dielectric constant and a low dielectric loss tangent even in a high frequency band (high frequency region) from the MHz band to the GHz band. For this reason, it has been investigated that polyphenylene ether is used, for example, as a high frequency molding material. More specifically, polyphenylene ether is preferably used as a substrate material for forming a substrate of a wiring board to be provided in electronic equipment utilizing a high frequency band.

Meanwhile, a molding material such as a substrate material is required to exhibit not only excellent low dielectric properties but also excellent heat resistance and the like. Thus, it is considered that polyphenylene ether is modified to enhance the heat resistance.

Examples of such a substrate material include a prepreg and a laminate which are obtained using a resin composition containing modified polyphenylene ether. JP 2009-161725 A describes a curable resin composition containing a vinyl compound having a polyphenylene ether skeleton in the molecule and a bismaleimide compound having a predetermined structure. JP 2009-161725 A discloses that a curable resin composition can be obtained which provides a cured product having a low dielectric constant, a low dielectric loss tangent, and excellent heat resistance, mechanical properties, chemical resistance, and flame retardancy, exhibits excellent curability even in the presence of oxygen, and is curable at low temperature.

Wiring boards to be used in various kinds of electronic equipment are required to be hardly affected by changes in the external environment and the like. Substrate materials for forming substrates of wiring boards are required to provide a cured product exhibiting excellent heat resistance such as a high glass transition temperature, for example, so that the wiring boards can be used even in an environment in which the temperature is relatively high. Moreover, it is required that moisture absorption into substrates of wiring boards are suppressed by decreasing the water absorbing property of the substrates of wiring boards so that the wiring boards can be used even in an environment in which the humidity is high. In addition, substrates of wiring boards are required to maintain low dielectric properties even if they absorb water. For this reason, substrate materials for forming substrates of wiring boards are required to provide a cured product which exhibits low water absorbing property and can suitably maintain low dielectric properties even after water absorption. In other words, substrate materials for forming substrates of wiring boards are required to provide a cured product in which increases in dielectric constant and dielectric loss tangent due to water absorption are sufficiently suppressed.

US 2017/166729 A1 describes a low-dielectric resin composition that includes a phosphorus-containing flame retardant and a resin with an active unsaturated bond, wherein the resin with an active unsaturated bond is a polymer, and oligomer or monomer which comprises one or more reactive functional groups.

### Summary of Invention

The present invention has been made in view of such circumstances, and an object thereof is to provide a resin composition from which a cured product, having a high glass transition temperature, a low water absorption rate, and sufficiently suppressed increases in dielectric constant and dielectric loss tangent due to water absorption even after water absorption, is suitably obtained. Another object of the present invention is to provide a prepreg, a film with resin, a metal foil with resin, a metal-clad laminate, and a wiring board which are obtained using the resin composition.

The present invention relates to a resin composition according to claim 1, a prepreg according to claim 7, a film according to claim 8, a metal foil according to claim 9, and a metal-clad laminate according to claim 10. Claims 2 to 6 refer to specifically advantageous realizations of the resin composition according to claim 1.

An aspect of the present invention is a resin composition comprising a maleimide compound represented by the following Formula (1), a modified polyphenylene ether compound of which a terminal is modified with a substituent having a carbon-carbon unsaturated double bond, and a crosslinking agent containing an allyl compound.

[Chem. 1]

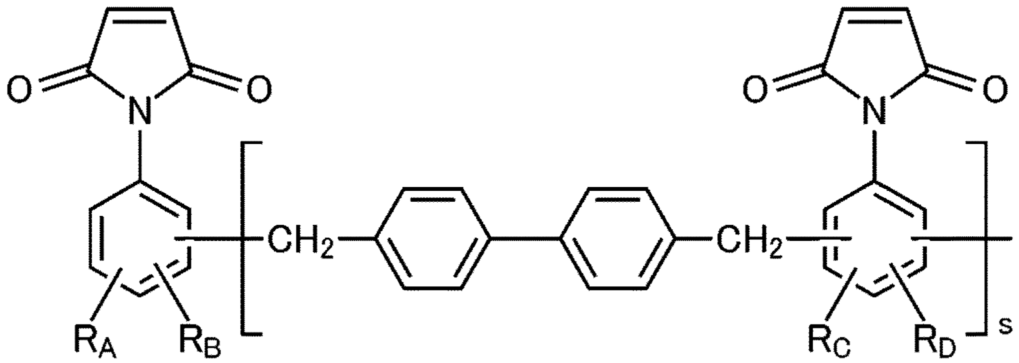

(1)

In Formula (1), s represents 1 to 5 and $R_A$, $R_B$, $R_C$, and $R_D$ each independently represent a hydrogen atom, an alkyl group having 1 to 5 carbon atoms, or a phenyl group.

The above and other objects, features, and advantages of the present invention will be apparent from the following detailed description.

**Brief Description of Drawings**

FIG. 1 is a schematic sectional view illustrating an example of a prepreg according to an embodiment of the present invention.

FIG. 2 is a schematic sectional view illustrating an example of a metal-clad laminate according to an embodiment of the present invention.

FIG. 3 is a schematic sectional view illustrating an example of a wiring board according to an embodiment of the present invention.

FIG. 4 is a schematic sectional view illustrating an example of a metal foil with resin according to an embodiment of the present invention.

FIG. 5 is a schematic sectional view illustrating an example of a film with resin according to an embodiment of the present invention.

**Description of Embodiments**

Hereinafter, embodiments according to the present invention will be described, but the present invention is not limited thereto.

[Resin composition]

A resin composition according to the present embodiment contains a maleimide compound represented by the following Formula (1), a modified polyphenylene ether compound of which a terminal is modified with a substituent having a carbon-carbon unsaturated double bond, and a crosslinking agent containing an allyl compound.

[Chem. 2]

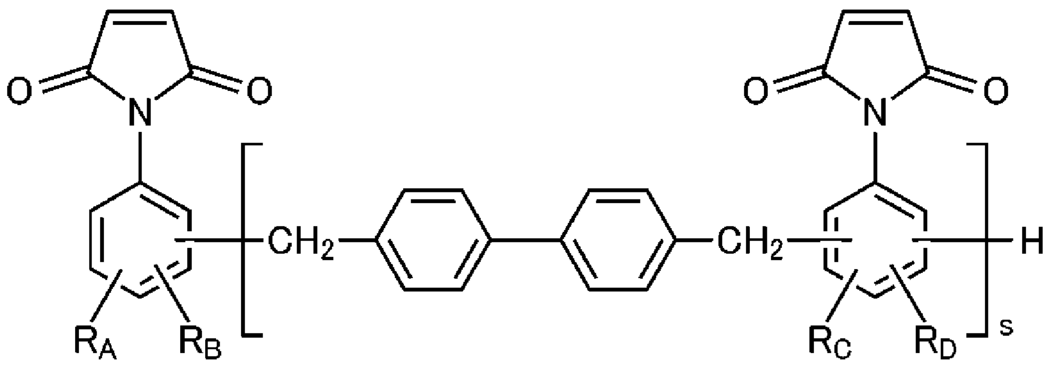

(1)

In Formula (1), s represents 1 to 5 and $R_A$, $R_B$, $R_C$, and $R_D$ each independently represent a hydrogen atom, an alkyl group having 1 to 5 carbon atoms, or a phenyl group.

First, it is considered that a cured product which maintains the excellent low dielectric properties of polyphenylene ether is obtained from the resin composition by crosslinking the modified polyphenylene ether compound with the maleimide compound and the crosslinking agent.

A maleimide compound tends to increase the glass transition temperature when being contained in a resin composition. According to the investigations by the present inventors, when a maleimide compound is simply added to a resin composition containing the modified polyphenylene ether compound and the crosslinking agent, even though the glass transition temperature can be increased, the water absorption rate of a cured product of the resin composition increases and further increases in the dielectric constant and dielectric loss tangent due to water absorption cannot be sufficiently suppressed after water absorption in some cases. In other words, the low dielectric properties cannot be sufficiently maintained after water absorption in some cases. This is presumed to be because a maleimide compound tends to increase the glass transition temperature when being added to a resin composition but the water absorption rate of a cured product of the obtained resin composition increases and further the low dielectric properties after water absorption cannot be maintained. Hence, as a result of various investigations, the present inventors have found out that not only the glass transition temperature can be increased but also the low dielectric properties can be suitably maintained even after water absorption while sufficiently suppressing an increase in the water absorption rate by containing a maleimide compound represented by Formula (1) among maleimide compounds.

In addition, according to the investigations by the present inventors, when a maleimide compound is contained in a resin composition containing a modified polyphenylene ether compound, the compatibility of the maleimide compound with the resin composition containing a modified polyphenylene ether compound is low and a suitable varnish is not obtained in some cases when the obtained resin composition is formed into a varnish. This is presumed to be because the maleimide compound exhibits low solubility in the solvent used when the varnish is formed. Hence, as a result of various investigations, the present inventors have found out that the compatibility between the resin composition containing a modified polyphenylene ether compound and a maleimide compound is enhanced and a varnish is suitably obtained when a maleimide compound represented by Formula (1) is used as the maleimide compound and further a crosslinking agent containing an allyl compound is used as the crosslinking agent. This is presumed to be because the maleimide compound exhibits high solubility in the solvent used when the varnish is formed and the allyl compound enhances the compatibility between the modified polyphenylene ether compound and the maleimide compound represented by Formula (1).

As described above, the resin composition having the above configuration is a resin composition from which a cured product, having a high glass transition temperature, a low water absorption rate, and sufficiently suppressed increases in the dielectric constant and dielectric loss tangent due to water absorption even after water absorption, is suitably obtained from the above description.

(Maleimide compound)

The maleimide compound is not particularly limited as long as it is a maleimide compound represented by Formula (1). Here, s, which is the number of repetitions, is 1 to 5 and preferably more than 1 and 5 or less. This s is an average value of the number of repetitions (degree of polymerization). When s is too small, there is a tendency that the modified polyphenylene ether compound, the maleimide compound, and the crosslinking agent are not sufficiently crosslinked with each other even when these are crosslinked with each other. $R_A$, $R_B$, $R_C$, and $R_D$ each independently represent a hydrogen atom, an alkyl group having 1 to 5 carbon atoms, or a phenyl group. In other words, $R_A$, $R_B$, $R_C$,

and $R_D$ may be the same group as or different groups from each other. $R_A$, $R_B$, $R_C$, and $R_D$ represent a hydrogen atom, an alkyl group having 1 to 5 carbon atoms, or a phenyl group. Among these, a hydrogen atom is preferable. In addition, examples of the alkyl group having 1 to 5 carbon atoms include a methyl group, an ethyl group, a propyl group, an isopropyl group, an n-butyl group, a sec-butyl group, an isobutyl group, a tert-butyl group, a pentyl group, and a neopentyl group.

The molecular weight, specifically, the number average molecular weight of the maleimide compound is preferably 150 to 2000 and more preferably 400 to 1300. In addition, the weight average molecular weight is preferably 150 to 2500 and more preferably 400 to 1500. Moreover, the content of a bifunctional form represented by Formula (1), where s is 1, of the maleimide compound is preferably 30% to 70% by mass and more preferably 50% to 70% by mass. Moreover, the content of a polyfunctional form of a trifunctional or higher form represented by Formula (1), where s is 2 or more, is preferably 30% to 70% by mass and more preferably 30% to 50% by mass. Moreover, if s that is the average value of the number of repetitions (degree of polymerization) is 1 to 5, the maleimide compound may include a monofunctional form represented by Formula (1), where s is 0, or a polyfunctional form of a heptafunctional form or an octafunctional form represented by Formula (1), where s is 6 or more.

(Modified polyphenylene ether compound)

The modified polyphenylene ether compound to be used in the present embodiment is not particularly limited as long as it is a modified polyphenylene ether compound of which the terminal is modified with a substituent having a carbon-carbon unsaturated double bond.

The substituent having a carbon-carbon unsaturated double bond is not particularly limited. Examples of the substituent include a substituent represented by the following Formula (2).

[Chem. 3]

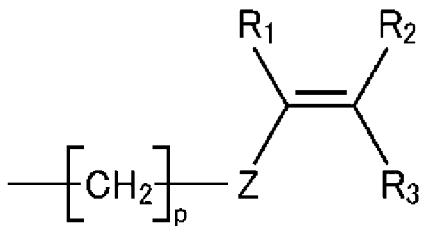

(2)

In Formula (2), p represents an integer 0 to 10. In addition, Z represents an arylene group. In addition, $R_1$ to $R_3$ are independent of each other. In other words, $R_1$ to $R_3$ may be the same group as or different groups from each other. In addition, $R_1$ to $R_3$ represent a hydrogen atom or an alkyl group.

In a case where p in Formula (2) is 0, it indicates that Z is directly bonded to the terminal of polyphenylene ether.

This arylene group is not particularly limited. Examples of this arylene group include a monocyclic aromatic group such as a phenylene group, and a polycyclic aromatic group in which the aromatic is not a single ring but a polycyclic aromatic such as a naphthalene ring. In addition, this arylene group also includes a derivative in which a hydrogen atom bonded to an aromatic ring is substituted with a functional group such as an alkenyl group, an alkynyl group, a formyl group, an alkylcarbonyl group, an alkenylcarbonyl group, or an alkynylcarbonyl group. In addition, the alkyl group is not particularly limited and is, for example, preferably an alkyl group having 1 to 18 carbon atoms and more preferably an alkyl group having 1 to 10 carbon atoms. Specific examples thereof include a methyl group, an ethyl group, a propyl group, a hexyl group, and a decyl group.

Preferred specific examples of the substituent represented by Formula (2) include a substituent represented by the following Formula (3) and a substituent having a vinylbenzyl group.

[Chem. 4]

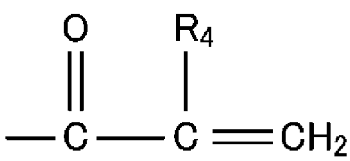

(3)

In Formula (3), $R_4$ represents a hydrogen atom or an alkyl group. The alkyl group is not particularly limited and is, for example, preferably an alkyl group having 1 to 18 carbon atoms and more preferably an alkyl group having 1 to

10 carbon atoms. Specific examples thereof include a methyl group, an ethyl group, a propyl group, a hexyl group, and a decyl group. In addition, examples of the substituent represented by Formula (3) include an acrylate group and a methacrylate group.

In addition, examples of the substituent having a vinylbenzyl group include a substituent represented by the following Formula (4).

[Chem. 5]

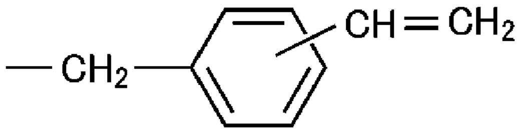

(4)

More specific examples of the substituent include vinylbenzyl groups (ethenylbenzyl groups) such as a p-ethenylbenzyl group and an m-ethenylbenzyl group, a vinylphenyl group, an acrylate group, and a methacrylate group.

The modified polyphenylene ether compound has a polyphenylene ether chain in the molecule and preferably has, for example, a repeating unit represented by the following Formula (5) in the molecule.

[Chem. 6]

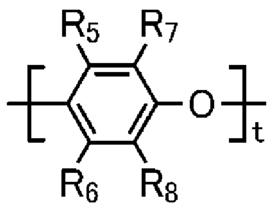

(5)

In Formula (5), t represents 1 to 50. In addition, $R_5$ to $R_8$ are independent of each other. In other words, $R_5$ to $R_8$ may be the same group as or different groups from each other. In addition, $R_5$ to $R_8$ represent a hydrogen atom, an alkyl group, an alkenyl group, an alkynyl group, a formyl group, an alkylcarbonyl group, an alkenylcarbonyl group, or an alkynylcarbonyl group. Among these, a hydrogen atom and an alkyl group are preferable.

Specific examples of the functional groups mentioned in $R_5$ to $R_8$ include the following.

The alkyl group is not particularly limited and is, for example, preferably an alkyl group having 1 to 18 carbon atoms and more preferably an alkyl group having 1 to 10 carbon atoms. Specific examples thereof include a methyl group, an ethyl group, a propyl group, a hexyl group, and a decyl group.

The alkenyl group is not particularly limited and is, for example, preferably an alkenyl group having 2 to 18 carbon atoms and more preferably an alkenyl group having 2 to 10 carbon atoms. Specific examples thereof include a vinyl group, an allyl group, and a 3-butenyl group.

The alkynyl group is not particularly limited and is, for example, preferably an alkynyl group having 2 to 18 carbon atoms and more preferably an alkynyl group having 2 to 10 carbon atoms. Specific examples thereof include an ethynyl group and a prop-2-yn-1-yl group (propargyl group).

The alkylcarbonyl group is not particularly limited as long as it is a carbonyl group substituted with an alkyl group and is, for example, preferably an alkylcarbonyl group having 2 to 18 carbon atoms and more preferably an alkylcarbonyl group having 2 to 10 carbon atoms.

Specific examples thereof include an acetyl group, a propionyl group, a butyryl group, an isobutyryl group, a pivaloyl group, a hexanoyl group, an octanoyl group, and a cyclohexylcarbonyl group.

The alkenylcarbonyl group is not particularly limited as long as it is a carbonyl group substituted with an alkenyl group and is, for example, preferably an alkenylcarbonyl group having 3 to 18 carbon atoms and more preferably an alkenylcarbonyl group having 3 to 10 carbon atoms. Specific examples thereof include an acryloyl group, a methacryloyl group, and a crotonoyl group.

The alkynylcarbonyl group is not particularly limited as long as it is a carbonyl group substituted with an alkynyl group and is, for example, preferably an alkynylcarbonyl group having 3 to 18 carbon atoms and more preferably an alkynylcarbonyl group having 3 to 10 carbon atoms. Specific examples thereof include a propioloyl group.

The weight average molecular weight (Mw) of the modified polyphenylene ether compound to be used in the present embodiment is not particularly limited. Specifically, the weight average molecular weight is preferably 500 to 5000, more preferably 800 to 4000, and still more preferably 1000 to 3000. Note that the weight average molecular

weight here may be measured by a general molecular weight measurement method, and specific examples thereof include a value measured by gel permeation chromatography (GPC). In addition, in a case where the modified polyphenylene ether compound has a repeating unit represented by Formula (5) in the molecule, t is preferably a numerical value so that the weight average molecular weight of the modified polyphenylene ether compound is in such a range. Specifically, t is preferably 1 to 50.

When the weight average molecular weight of the modified polyphenylene ether compound is in such a range, the modified polyphenylene ether compound exhibits the excellent low dielectric properties of polyphenylene ether and not only imparts superior heat resistance to the cured product but also exhibits excellent moldability. This is considered to be due to the following. When the weight average molecular weight of ordinary polyphenylene ether is in such a range, the heat resistance of the cured product tends to decrease since the molecular weight is relatively low. With regard to this point, since the modified polyphenylene ether compound according to the present embodiment has one or more unsaturated double bonds at the terminal, it is considered that a cured product exhibiting sufficiently high heat resistance is obtained. Moreover, when the weight average molecular weight of the modified polyphenylene ether compound is in such a range, the modified polyphenylene ether compound has a relatively low molecular weight and thus is considered to exhibit excellent moldability. Hence, it is considered that such a modified polyphenylene ether compound not only imparts superior heat resistance to the cured product but also exhibits excellent moldability.

Moreover, the average number of the substituents at the molecular terminal (the number of terminal functional groups) per one molecule of modified polyphenylene ether in the modified polyphenylene ether compound to be used in the present embodiment is not particularly limited. Specifically, the average number is preferably 1 to 5, more preferably 1 to 3, and still more preferably 1.5 to 3. When the number of terminal functional groups is too small, sufficient heat resistance of the cured product tends to be hardly attained. In addition, when the number of terminal functional groups is too large, the reactivity is too high and, for example, troubles such as deterioration in the storage stability of the resin composition or deterioration in the fluidity of the resin composition may occur. In other words, when such a modified polyphenylene ether is used, for example, molding defects such as generation of voids at the time of multilayer molding occur by insufficient fluidity and the like and a problem of moldability that a highly reliable printed wiring board is hardly obtained may occur.

The number of terminal functional groups in the modified polyphenylene ether compound includes a numerical value expressing the average value of the substituents per one molecule of all the modified polyphenylene ether compounds present in 1 mole of the modified polyphenylene ether compound. This number of terminal functional groups can be determined, for example, by measuring the number of hydroxyl groups remaining in the obtained modified polyphenylene ether compound and calculating the number of hydroxyl groups decreased from the number of hydroxyl groups in the polyphenylene ether before being modified. The number of hydroxyl groups decreased from the number of hydroxyl groups in the polyphenylene ether before being modified is the number of terminal functional groups. Moreover, with regard to the method for measuring the number of hydroxyl groups remaining in the modified polyphenylene ether compound, the number of hydroxyl groups can be determined by adding a quaternary ammonium salt (tetraethylammonium hydroxide) to be associated with a hydroxyl group to a solution of the modified polyphenylene ether compound and measuring the UV absorbance of the mixed solution.

In addition, the intrinsic viscosity of the modified polyphenylene ether compound to be used in the present embodiment is not particularly limited. Specifically, the intrinsic viscosity may be 0.03 to 0.12 dl/g, and is preferably 0.04 to 0.11 dl/g and more preferably 0.06 to 0.095 dl/g. When the intrinsic viscosity is too low, the molecular weight tends to be low and low dielectric properties such as a low dielectric constant and a low dielectric loss tangent tend to be hardly attained. In addition, when the intrinsic viscosity is too high, the viscosity is high, sufficient fluidity is not attained, and the moldability of the cured product tends to deteriorate. Hence, if the intrinsic viscosity of the modified polyphenylene ether compound is in the above range, excellent heat resistance and moldability of the cured product can be realized.

Note that the intrinsic viscosity here is an intrinsic viscosity measured in methylene chloride at 25°C and more specifically is, for example, a value attained by measuring the intrinsic viscosity of a methylene chloride solution (liquid temperature: 25°C) at 0.18 g/45 ml using a viscometer. Examples of the viscometer include AVS500 Visco System manufactured by SCHOTT Instruments GmbH.

Examples of the modified polyphenylene ether compound include a modified polyphenylene ether compound represented by the following Formula (6) and a modified polyphenylene ether compound represented by the following Formula (7). Moreover, as the modified polyphenylene ether compound, these modified polyphenylene ether compounds may be used singly or these two kinds of modified polyphenylene ether compounds may be used in combination.

[Chem. 7]

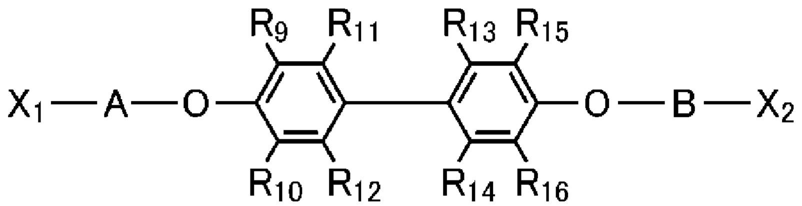

(6)

[Chem. 8]

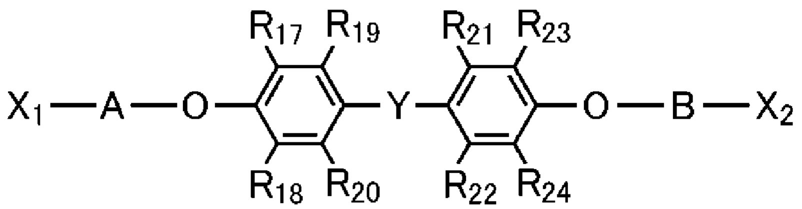

(7)

In Formulas (6) and (7), $R_9$ to $R_{16}$ and $R_{17}$ to $R_{24}$ each independently represent a hydrogen atom, an alkyl group, an alkenyl group, an alkynyl group, a formyl group, an alkylcarbonyl group, an alkenylcarbonyl group, or an alkynylcarbonyl group. $X_1$ and $X_2$ each independently represent a substituent having a carbon-carbon unsaturated double bond. A and B represent repeating units represented by the following Formulas (8) and (9), respectively. In addition, in Formula (7), Y represents a linear, branched, or cyclic hydrocarbon having 20 or less carbon atoms.

[Chem. 9]

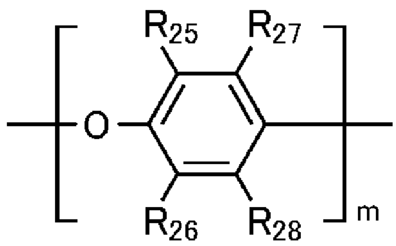

(8)

[Chem. 10]

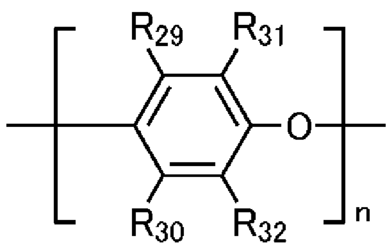

(9)

In Formulas (8) and (9), m and n each represent 0 to 20. $R_{25}$ to $R_{28}$ and $R_{29}$ to $R_{32}$ each independently represent a hydrogen atom, an alkyl group, an alkenyl group, an alkynyl group, a formyl group, an alkylcarbonyl group, an alkenylcarbonyl group, or an alkynylcarbonyl group.

The modified polyphenylene ether compound represented by Formula (6) and the modified polyphenylene ether compound represented by Formula (7) are not particularly limited as long as they satisfy the above configuration. Specifically, in Formulas (6) and (7), $R_9$ to $R_{16}$ and $R_{17}$ to $R_{24}$ are independent of each other as described above. In other words, $R_9$ to $R_{16}$ and $R_{17}$ to $R_{24}$ may be the same group as or different groups from each other. In addition, $R_9$ to $R_{16}$ and $R_{17}$ to $R_{24}$ represent a hydrogen atom, an alkyl group, an alkenyl group, an alkynyl group, a formyl group, an alkylcarbonyl group, an alkenylcarbonyl group, or an alkynylcarbonyl group. Among these, a hydrogen atom and an

alkyl group are preferable.

In addition, in Formulas (8) and (9), m and n each preferably represent 0 to 20 as described above. In addition, it is preferable that m and n represent numerical values so that the sum of m and n is 1 to 30. Hence, it is more preferable that m represents 0 to 20, n represents 0 to 20, and the sum of m and n represents 1 to 30. In addition, $R_{25}$ to $R_{28}$ and $R_{29}$ to $R_{32}$ are independent of each other. In other words, $R_{25}$ to $R_{28}$ and $R_{29}$ to $R_{32}$ may be the same group as or different groups from each other. In addition, $R_{25}$ to $R_{28}$ and $R_{29}$ to $R_{32}$ represent a hydrogen atom, an alkyl group, an alkenyl group, an alkynyl group, a formyl group, an alkylcarbonyl group, an alkenylcarbonyl group, or an alkynylcarbonyl group. Among these, a hydrogen atom and an alkyl group are preferable.

$R_9$ to $R_{32}$ are the same as $R_5$ to $R_8$ in Formula (5).

In Formula (7), Y represents a linear, branched, or cyclic hydrocarbon having 20 or less carbon atoms as described above. Examples of Y include a group represented by the following Formula (10).

[Chem. 11]

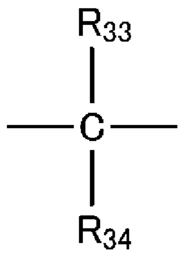

(10)

In Formula (10), $R_{33}$ and $R_{34}$ each independently represent a hydrogen atom or an alkyl group. Examples of the alkyl group include a methyl group. Moreover, examples of the group represented by Formula (10) include a methylene group, a methylmethylene group, and a dimethylmethylene group. Among these, a dimethylmethylene group is preferable.

In Formulas (6) and (7), $X_1$ and $X_2$ each independently represent a substituent having a carbon-carbon unsaturated double bond. The substituents $X_1$ and $X_2$ are not particularly limited as long as they are substituents having a carbon-carbon unsaturated double bond. Examples of the substituents $X_1$ and $X_2$ include a substituent represented by Formula (2). In the modified polyphenylene ether compound represented by Formula (6) and the modified polyphenylene ether compound represented by Formula (7), $X_1$ and $X_2$ may be the same substituent as or different substituents from each other.

More specific examples of the modified polyphenylene ether compound represented by Formula (6) include a modified polyphenylene ether compound represented by the following Formula (11).

[Chem. 12]

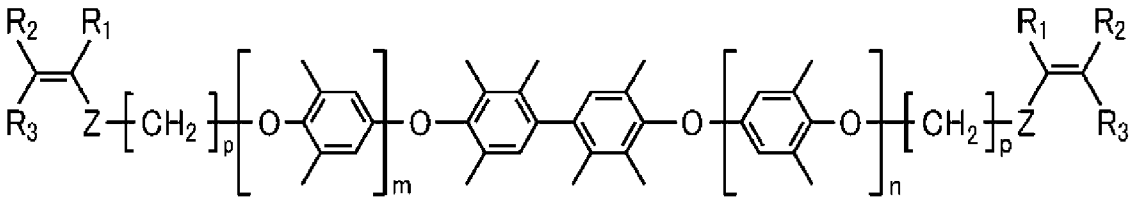

(11)

More specific examples of the modified polyphenylene ether compound represented by Formula (7) include a modified polyphenylene ether compound represented by the following Formula (12) and a modified polyphenylene ether compound represented by the following Formula (13).

[Chem. 13]

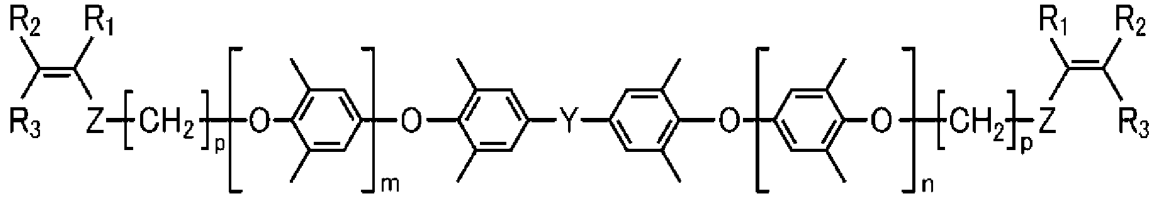

(12)

[Chem. 14]

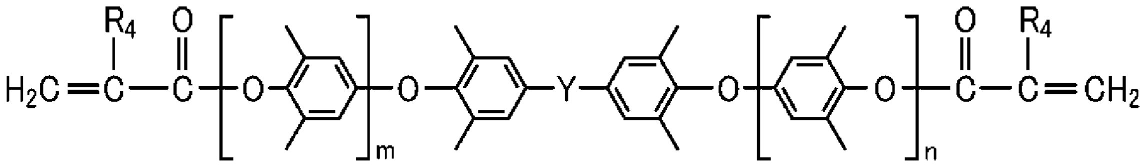

(13)

In Formulas (11) to (13), m and n are the same as m and n in Formulas (8) and (9). In addition, in Formulas (11) and (12), $R_1$ to $R_3$ and p are the same as $R_1$ to $R_3$ and p in Formula (2). In addition, in Formulas (12) and (13), Y is the same as Y in the above Formula (7). In addition, in Formula (13), $R_4$ is the same as $R_4$ in Formula (3).

In addition, the average number of the substituents at the molecular terminal (the number of terminal functional groups) per one molecule of the modified polyphenylene ether in the modified polyphenylene ether compound to be used in the present embodiment includes the range described above, but specifically is preferably 1 to 2 and more preferably 1.5 to 2, for example, in the case of the modified polyphenylene ether compounds represented by Formulas (11) to (13).

The method for synthesizing the modified polyphenylene ether compound to be used in the present embodiment is not particularly limited as long as a modified polyphenylene ether compound of which the terminal is modified with a substituent having a carbon-carbon unsaturated double bond can be synthesized. Specific examples thereof include a method in which polyphenylene ether is reacted with a compound in which a substituent having a carbon-carbon unsaturated double bond is bonded to a halogen atom.

Examples of the compound in which a substituent having a carbon-carbon unsaturated double bond is bonded to a halogen atom include compounds in which substituents represented by Formulas (2) to (4) are bonded to a halogen atom. Specific examples of the halogen atom include a chlorine atom, a bromine atom, an iodine atom, and a fluorine atom. Among these, a chlorine atom is preferable. More specific examples of the compound in which a substituent having a carbon-carbon unsaturated double bond is bonded to a halogen atom include p-chloromethylstyrene and m-chloromethylstyrene.

Polyphenylene ether which is a raw material is not particularly limited as long as a predetermined modified polyphenylene ether compound can be finally synthesized. Specific examples thereof include those containing polyphenylene ether containing 2,6-dimethylphenol and at least one of a bifunctional phenol and a trifunctional phenol and polyphenylene ether such as poly(2,6-dimethyl-1,4-phenylene oxide) as a main component. In addition, the bifunctional phenol is a phenol compound having two phenolic hydroxyl groups in the molecule, and examples thereof include tetramethyl bisphenol A. In addition, the trifunctional phenol is a phenol compound having three phenolic hydroxyl groups in the molecule.

Examples of the method for synthesizing the modified polyphenylene ether compound include the methods described above. Specifically, polyphenylene ether as described above and a compound in which a substituent having a carbon-carbon unsaturated double bond is bonded to a halogen atom are dissolved in a solvent and stirred. By doing so, polyphenylene ether reacts with the compound in which a substituent having a carbon-carbon unsaturated double bond is bonded to a halogen atom, and the modified polyphenylene ether compound to be used in the present embodiment is obtained.

The reaction is preferably conducted in the presence of an alkali metal hydroxide. By doing so, it is considered that this reaction suitably proceeds. This is considered to be because the alkali metal hydroxide functions as a dehydrohalogenating agent, specifically, a dehydrochlorinating agent. In other words, it is considered that the alkali metal hydroxide eliminates the hydrogen halide from the phenol group in polyphenylene ether and the compound in which a substituent having a carbon-carbon unsaturated double bond is bonded to a halogen atom, and by doing so, the substituent having a carbon-carbon unsaturated double bond is bonded to the oxygen atom of the phenol group instead of the hydrogen atom of the phenol group in the polyphenylene ether.

The alkali metal hydroxide is not particularly limited as long as it can act as a dehalogenating agent, and

examples thereof include sodium hydroxide. In addition, the alkali metal hydroxide is usually used in the form of an aqueous solution and is specifically used as an aqueous sodium hydroxide solution.

The reaction conditions such as reaction time and reaction temperature also vary depending on the compound in which a substituent having a carbon-carbon unsaturated double bond is bonded to a halogen atom and the like, and are not particularly limited as long as they are conditions under which the reaction as described above suitably proceeds. Specifically, the reaction temperature is preferably room temperature to 100°C and more preferably 30°C to 100°C. In addition, the reaction time is preferably 0.5 to 20 hours and more preferably 0.5 to 10 hours.

The solvent to be used at the time of the reaction is not particularly limited as long as it can dissolve polyphenylene ether and the compound in which a substituent having a carbon-carbon unsaturated double bond is bonded to a halogen atom, and does not inhibit the reaction of polyphenylene ether with the compound in which a substituent having a carbon-carbon unsaturated double bond is bonded to a halogen atom. Specific examples thereof include toluene.

The above reaction is preferably conducted in the presence of not only an alkali metal hydroxide but also a phase transfer catalyst. In other words, the above reaction is preferably conducted in the presence of an alkali metal hydroxide and a phase transfer catalyst. By doing so, it is considered that the above reaction more suitably proceeds. This is considered to be due to the following. This is considered to be because the phase transfer catalyst is a catalyst which has a function of taking in the alkali metal hydroxide, is soluble in both phases of a phase of a polar solvent such as water and a phase of a non-polar solvent such as an organic solvent, and can transfer between these phases. Specifically, in a case where an aqueous sodium hydroxide solution is used as an alkali metal hydroxide and an organic solvent, such as toluene, which is incompatible with water is used as a solvent, it is considered that even when the aqueous sodium hydroxide solution is dropped into the solvent subjected to the reaction, the solvent and the aqueous sodium hydroxide solution are separated from each other and the sodium hydroxide is hardly transferred to the solvent. In that case, it is considered that the aqueous sodium hydroxide solution added as an alkali metal hydroxide hardly contributes to the promotion of the reaction. In contrast, when the reaction is conducted in the presence of an alkali metal hydroxide and a phase transfer catalyst, it is considered that the alkali metal hydroxide is transferred to the solvent in the state of being taken in the phase transfer catalyst and the aqueous sodium hydroxide solution is likely to contribute to the promotion of the reaction. For this reason, when the reaction is conducted in the presence of an alkali metal hydroxide and a phase transfer catalyst, it is considered that the above reaction more suitably proceeds.

The phase transfer catalyst is not particularly limited, and examples thereof include quaternary ammonium salts such as tetra-n-butylammonium bromide.

The resin composition to be used in the present embodiment preferably contains a modified polyphenylene ether compound obtained as described above as the modified polyphenylene ether compound.

(Crosslinking agent)

The crosslinking agent to be used in the present embodiment is not particularly limited as long as it contains an allyl compound, can form crosslinks in a resin composition containing the modified polyphenylene ether compound and the maleimide compound, and can cure the resin composition. Moreover, the crosslinking agent only needs to contain an allyl compound and may contain a crosslinking agent other than an allyl compound or the crosslinking agent may be composed of an allyl compound.

The allyl compound is not particularly limited as long as it is a compound having an allyl group in the molecule. As the allyl compound, for example, triallyl isocyanurate (TAIC) and bisphenol in which an aromatic hydrogen element is substituted with an allyl group are preferably used. Examples of the bisphenol in which an aromatic hydrogen element is substituted with an allyl group include diallyl bisphenol such as 2,2'-diallyl bisphenol A (DABPA). These may be used singly or in combination of two kinds thereof. For example, concurrent use of triallyl isocyanurate (TAIC) with diallyl bisphenol such as 2,2'-diallylbisphenol A (DABPA) can be mentioned. In the case of such concurrent use, the TAIC content is preferably equal to or more than the diallyl bisphenol content in consideration of the deterioration in resin flowability of the resin composition in a case where the resin composition is stored at 40°C. Furthermore, it is more preferable that the allyl compound is not concurrent use of TAIC with diallyl bisphenol but only TAIC in consideration of the deterioration in resin flowability of the resin composition in a case where the resin composition is stored at 40°C.

Examples of the crosslinking agent other than the allyl compound include styrene, divinylbenzene, an acrylate compound, a methacrylate compound, polybutadiene, and a maleimide compound other than the maleimide compound represented by the above Formula (1). Examples of the acrylate compound include a polyfunctional acrylate compound having two or more acryloyl groups in the molecule such as tricyclodecane dimethanol diacrylate. Examples of the methacrylate compound include a polyfunctional methacrylate compound having two or more methacryloyl groups in the molecule such as tricyclodecane dimethanol dimethacrylate (DCP). In addition, examples of the crosslinking agent other than the allyl compound also include a polyfunctional vinyl compound having two or more vinyl groups in the molecule such as the polybutadiene and vinylbenzyl compounds having a vinylbenzyl group in the molecule such as styrene and divinylbenzene. Among these, those having two or more carbon-carbon double bonds in the molecule are

preferable. Specific examples thereof include a polyfunctional acrylate compound, a polyfunctional methacrylate compound, a polyfunctional vinyl compound, and divinylbenzene. Moreover, among these, a polyfunctional acrylate compound and a polyfunctional methacrylate compound are preferable, a dimethacrylate compound is more preferable, and tricyclodecane dimethanol dimethacrylate (DCP) is still more preferable. When these are used, it is considered that crosslinks are more suitably formed by a curing reaction, and the heat resistance of a cured product of the resin composition according to the present embodiment can be further enhanced. In addition, as the crosslinking agent, the crosslinking agents exemplified may be used singly or in combination of two or more kinds thereof. Moreover, as the crosslinking agent, a compound having two or more carbon-carbon double bonds in the molecule and a compound having one carbon-carbon double bond in the molecule may be used concurrently. Specific examples of the compound having one carbon-carbon double bond in the molecule include a monovinyl compound having one vinyl group in the molecule such as styrene.

It is preferable that the crosslinking agent contains the allyl compound and further contains a crosslinking agent other than the allyl compound as described above. Moreover, the crosslinking agent other than the allyl compound, the polyfunctional acrylate compound and the polyfunctional methacrylate compound are preferable and the dimethacrylate compound is more preferable. In other words, as the crosslinking agent, it is preferable to concurrently use the allyl compound with at least one of the polyfunctional acrylate compound and the polyfunctional methacrylate compound, and it is more preferable to concurrently use the allyl compound and a dimethacrylate compound as described above. As described above, by containing the allyl compound, the obtained resin composition becomes a resin composition from which a cured product, having a high glass transition temperature, a low water absorption rate, and suitably maintained low dielectric properties even after water absorption, is obtained. This is considered to be because the allyl compound enables the effect by the addition of a maleimide compound to be suitably exerted. Furthermore, the allyl compound can enhance the compatibility between the maleimide compound and the modified polyphenylene ether compound, and it is thus possible to suitably obtain a resin composition from which a cured product, having a high glass transition temperature, a low water absorption rate, and suitably maintained low dielectric properties even after water absorption, is obtained by adding the allyl compound. On the other hand, an allyl compound exhibits relatively high volatility, and it is thus considered that the glass transition temperature can be further increased by using not only an allyl compound but also a crosslinking agent containing a dimethacrylate compound which exhibits lower volatility than the allyl compound. Hence, by concurrently using the allyl compound and a dimethacrylate compound, the obtained resin composition becomes a resin composition from which a cured product, having a higher glass transition temperature, a low water absorption rate, and suitably maintained low dielectric properties even after water absorption, is suitably obtained. Moreover, the moldability can also be enhanced by containing a dimethacrylate compound exhibiting relatively low volatility as a crosslinking agent.

The crosslinking agent only needs to contain an allyl compound or may contain a crosslinking agent other than the allyl compound as described above. In addition, the crosslinking agent may be composed of an allyl compound. In other words, the content of the allyl compound may be 100 parts by mass with respect to 100 parts by mass of the crosslinking agent. Moreover, the crosslinking agent may be composed of an allyl compound or may be concurrent use of an allyl compound with a crosslinking agent other than the allyl compound, and thus the content of the allyl compound is preferably in the following range with respect to the entire amount of the crosslinking agent. The content of the allyl compound is preferably 20 to 100 parts by mass, more preferably 30 to 90 parts by mass, and still more preferably 60 to 90 parts by mass with respect to 100 parts by mass of the crosslinking agent. When the amount of the allyl compound is too small, the effect by the addition of an allyl compound tends to be insufficiently exerted. In other words, there is a tendency that the compatibility between the maleimide compound and the modified polyphenylene ether compound cannot be sufficiently enhanced. Hence, the effect by the addition of a maleimide compound that a cured product, having a high glass transition temperature, a low water absorption rate, and suitably maintained low dielectric properties even after water absorption, is obtained tends to be hardly exerted. In other words, a cured product having a high glass transition temperature, a low water absorption rate, and suitably maintained low dielectric properties even after water absorption tends to be hardly obtained.

(Content)

The content of the maleimide compound is 10 to 60 parts by mass, preferably 20 to 50 parts by mass, and more preferably 25 to 40 parts by mass with respect to 100 parts by mass of the total mass of the maleimide compound, the modified polyphenylene ether compound, and the crosslinking agent. In addition, the content of the modified polyphenylene ether compound is preferably 10 to 75 parts by mass, more preferably 20 to 60 parts by mass, and still more preferably 30 to 50 parts by mass with respect to 100 parts by mass of the total mass of the maleimide compound, the modified polyphenylene ether compound, and the crosslinking agent. In addition, the content of the crosslinking agent is preferably 10 to 50 parts by mass, more preferably 20 to 40 parts by mass, and still more preferably 25 to 35 parts by mass with respect to 100 parts by mass of the total mass of the maleimide compound, the modified polyphenylene

ether compound, and the crosslinking agent. In addition, the content of the allyl compound is preferably in the above range with respect to 100 parts by mass of the crosslinking agent, but is preferably 10 to 50 parts by mass, more preferably 15 to 40 parts by mass, and still more preferably 20 to 30 parts by mass with respect to 100 parts by mass of the total mass of the maleimide compound, the modified polyphenylene ether compound, and the crosslinking agent. If the contents of the maleimide compound, the modified polyphenylene ether compound, the crosslinking agent, and the allyl compound are each in the above ranges, the obtained resin composition can suitably provide a cured product having a higher glass transition temperature, a lower water absorption rate, and further suppressed increases in the dielectric constant and dielectric loss tangent due to water absorption even after water absorption.

(Other components)

The resin composition according to the present embodiment may contain components (other components) other than the maleimide compound, the modified polyphenylene ether compound, and the crosslinking agent if necessary as long as the effects of the present invention are not impaired. As other components to be contained in the resin composition according to the present embodiment, for example, additives such as a silane coupling agent, a flame retardant, an initiator, an antifoaming agent, an antioxidant, a heat stabilizer, an antistatic agent, an ultraviolet absorber, a dye or pigment, a lubricant, and an inorganic filler may be further contained. In addition, the resin composition may contain thermosetting resins such as an epoxy resin, an unsaturated polyester resin, and a thermosetting polyimide resin in addition to the modified polyphenylene ether compound.

As described above, the resin composition according to the present embodiment may contain a silane coupling agent. The silane coupling agent may be contained in the resin composition or may be contained as a silane coupling agent covered on the inorganic filler to be contained in the resin composition for surface treatment in advance. Among these, it is preferable that the silane coupling agent is contained as a silane coupling agent covered on the inorganic filler for surface treatment in advance, and it is more preferable that the silane coupling agent is contained as a silane coupling agent covered on the inorganic filler for surface treatment in advance and further is also contained in the resin composition. Moreover, in the case of a prepreg, the silane coupling agent may be contained in the prepreg as a silane coupling agent covered on the fibrous base material for surface treatment in advance.

Examples of the silane coupling agent include a silane coupling agent having at least one functional group selected from the group consisting of a vinyl group, a styryl group, a methacryloyl group, an acryloyl group, and a phenylamino group. In other words, examples of this silane coupling agent include compounds having at least one of a vinyl group, a styryl group, a methacryloyl group, an acryloyl group, or a phenylamino group as a reactive functional group, and further a hydrolyzable group such as a methoxy group or an ethoxy group.

Examples of the silane coupling agent include vinyltriethoxysilane and vinyltrimethoxysilane as those having a vinyl group. Examples of the silane coupling agent include p-styryltrimethoxysilane and p-styryltriethoxysilane as those having a styryl group. Examples of the silane coupling agent include 3-methacryloxypropyltrimethoxysilane, 3-methacryloxypropylmethyldimethoxysilane, 3-methacryloxypropyltriethoxysilane, 3-methacryloxypropylmethyldiethoxysilane, and 3-methacryloxypropylethyldiethoxysilane as those having a methacryloyl group. Examples of the silane coupling agent include 3-acryloxypropyltrimethoxysilane and 3-acryloxypropyltriethoxysilane as those having an acryloyl group. Examples of the silane coupling agent include N-phenyl-3-aminopropyltrimethoxysilane and N-phenyl-3-aminopropyltriethoxysilane as those having a phenylamino group.

As described above, the resin composition according to the present embodiment may contain a flame retardant. The flame retardancy of a cured product of the resin composition can be enhanced by containing a flame retardant. The flame retardant is not particularly limited. Specifically, in the field in which halogen-based flame retardants such as bromine-based flame retardants are used, for example, ethylenedipentabromobenzene, ethylenebistetrabromoimide, decabromodiphenyloxide, and tetradecabromodiphenoxybenzene which have a melting point of 300°C or more are preferable. It is considered that the elimination of halogen at a high temperature and the deterioration in heat resistance can be suppressed by the use of a halogen-based flame retardant. In addition, in the field of being required to be free of halogen, a phosphoric ester-based flame retardant, a phosphazene-based flame retardant, a bis(diphenylphosphine oxide)-based flame retardant, and a phosphinate-based flame retardant are exemplified. Specific examples of the phosphoric ester-based flame retardant include a condensed phosphoric ester such as dixylenyl phosphate. Specific examples of the phosphazene-based flame retardant include phenoxyphosphazene. Specific examples of the bis(diphenylphosphine oxide)-based flame retardant include xylylenebis(diphenylphosphine oxide). Specific examples of the phosphinate-based flame retardant include metal phosphinates such as aluminum dialkyl phosphinate. As the flame retardant, the respective flame retardants exemplified may be used singly or in combination of two or more kinds thereof.

As described above, the resin composition according to the present embodiment may contain an initiator (reaction initiator). The curing reaction can proceed even when the polyphenylene ether resin composition is composed of the maleimide compound, the modified polyphenylene ether compound, and the crosslinking agent. In addition, the curing reaction can proceed even when the polyphenylene ether resin composition is composed only of modified polyphenylene ether. However, a reaction initiator may be added since there is a case where it is difficult to raise the temperature until curing proceeds depending on the process conditions. The reaction initiator is not particularly limited as long as it can promote the curing reaction of the maleimide compound, the modified polyphenylene ether compound, and the crosslinking agent. Specific examples thereof include oxidizing agents such as a,a'-bis(t-butylperoxy-m-isopropyl)benzene, 2,5-dimethyl-2,5-di(t-butylperoxy)-3-hexyne, benzoyl peroxide, 3,3',5,5'-tetramethyl-1,4-diphenoquinone, chloranil, 2,4,6-tri-t-butylphenoxyl, t-butylperoxyisopropyl monocarbonate, and azobisisobutyronitrile. Moreover, a metal carboxylate can be concurrently used if necessary. By doing so, the curing reaction can be further promoted. Among these, $\alpha,\alpha'$-bis(t-butylperoxy-m-isopropyl)benzene is preferably used. $\alpha,\alpha'$-bis(t-butylperoxy-m-isopropyl)benzene has a relatively high reaction initiation temperature and thus can suppress the promotion of the curing reaction at the time point at which curing is not required, for example, at the time of prepreg drying, and can suppress deterioration in the storage stability of the polyphenylene ether resin composition. Furthermore, $\alpha,\alpha'$-bis(t-butylperoxy-m-isopropyl)benzene exhibits low volatility, thus does not volatilize at the time of prepreg drying and storage, and exhibits favorable stability. In addition, the reaction initiator may be used singly or in combination of two or more kinds thereof.

As described above, the resin composition according to the present embodiment may contain a filler such as an inorganic filler. Examples of the filler include those to be added to enhance the heat resistance and flame retardancy of a cured product of the resin composition, but the filler is not particularly limited. In addition, the heat resistance, flame retardancy and the like can be further enhanced by containing a filler. Specific examples of the filler include silica such as spherical silica, metal oxides such as alumina, titanium oxide, and mica, metal hydroxides such as aluminum hydroxide and magnesium hydroxide, talc, aluminum borate, barium sulfate, and calcium carbonate. In addition, as the filler, silica, mica, and talc are preferable and spherical silica is more preferable among these. In addition, the filler may be used singly or in combination of two or more kinds thereof. In addition, the filler may be used as it is, or a filler subjected to a surface treatment with the silane coupling agent may be used. In addition, in a case where a filler is contained, the content thereof (filler content) is preferably 30% to 270% by mass and more preferably 50% to 250% by mass with respect to the resin composition.

Moreover, by using the resin composition according to the present embodiment, a prepreg, a metal-clad laminate, a wiring board, a metal foil with resin, and a film with resin can be obtained as described below.

FIG. 1 is a schematic sectional view illustrating an example of a prepreg 1 according to an embodiment of the present invention.

As illustrated in FIG. 1, the prepreg 1 according to the present embodiment includes the resin composition or a semi-cured product 2 of the resin composition and a fibrous base material 3. This prepreg 1 includes the resin composition or the semi-cured product 2 of the resin composition and the fibrous base material 3 present in the resin composition or the semi-cured product 2 of the resin composition.

In the present embodiment, the semi-cured product is in a state in which the resin composition has been cured to an extent that the resin composition can be further cured. In other words, the semi-cured product is in a state in which the resin composition has been semi-cured (B-staged). For example, when the resin composition is heated, the viscosity gradually decreases at first, and then curing starts, and the viscosity gradually increases. In such a case, the semi-cured state includes a state in which the viscosity has started to increase but curing is not completed, and the like.

In addition, the prepreg to be obtained using the resin composition according to the present embodiment may include a semi-cured product of the resin composition as described above or include the uncured resin composition itself. In other words, the prepreg may be a prepreg including a semi-cured product of the resin composition (the B-stage resin composition) and a fibrous base material or a prepreg including the resin composition before being cured (the A-stage resin composition) and a fibrous base material.

When manufacturing a prepreg, the resin composition 2 is often prepared in a varnish form and used in order to be impregnated into the fibrous base material 3 which is a base material for forming the prepreg. In other words, the resin composition 2 is usually a resin varnish prepared in a varnish form in many cases. Such a varnish-like resin composition (resin varnish) is prepared, for example, as follows.

First, the respective components which can be dissolved in an organic solvent are introduced into and dissolved in an organic solvent. At this time, heating may be performed if necessary. Thereafter, components which are used if necessary but are not dissolved in the organic solvent are added to and dispersed in the solution until a predetermined dispersion state is achieved using a ball mill, a bead mill, a planetary mixer, a roll mill or the like, whereby a varnish-like resin composition is prepared. The organic solvent to be used here is not particularly limited as long as it dissolves the maleimide compound, the modified polyphenylene ether compound, the crosslinking agent and the like and does not inhibit the curing reaction. Specific examples thereof include toluene and methyl ethyl ketone (MEK).

The method for manufacturing the prepreg is not particularly limited as long as the prepreg can be manufactured. Specifically, when manufacturing a prepreg, the resin composition which has been described above and is used in the present embodiment is often prepared in a varnish form and used as a resin varnish as described above.

Specific examples of the fibrous base material include glass cloth, aramid cloth, polyester cloth, a glass nonwoven fabric, an aramid nonwoven fabric, a polyester nonwoven fabric, pulp paper, and linter paper. When glass cloth

is used, a laminate exhibiting excellent mechanical strength is obtained, and glass cloth subjected to flattening is particularly preferable. Specific examples of the flattening include a method in which glass cloth is continuously pressed at an appropriate pressure using a press roll to flatly compress the yarn. The thickness of the generally used fibrous base material is, for example, 0.01 mm or more and 0.3 mm or less.

The method for manufacturing the prepreg is not particularly limited as long as the prepreg can be manufactured. Specifically, when manufacturing a prepreg, the resin composition according to the present embodiment described above is often prepared in a varnish form and used as a resin varnish as described above.

Examples of the method for manufacturing the prepreg 1 include a method in which the fibrous base material 3 is impregnated with the resin composition 2, for example, the resin composition 2 prepared in a varnish form, and then dried.

The fibrous base material 3 is impregnated with the resin composition 2 by dipping, coating, and the like. If necessary, the impregnation can be repeated a plurality of times. Moreover, at this time, it is also possible to finally adjust the composition and impregnated amount to the desired composition and impregnated amount by repeating impregnation using a plurality of resin compositions having different compositions and concentrations.

The fibrous base material 3 impregnated with the resin composition (resin varnish) 2 is heated under desired heating conditions, for example, at 80°C or more and 180°C or less for 1 minute or more and 10 minutes or less. By heating, the prepreg 1 before being cured (A-stage) or in a semi-cured state (B-stage) is obtained.

The resin composition according to the present embodiment is a resin composition from which a cured product, having a high glass transition temperature, a low water absorption rate, and sufficiently suppressed increases in the dielectric constant and dielectric loss tangent due to water absorption even after water absorption, is suitably obtained. For this reason, a prepreg including this resin composition or a semi-cured product of this resin composition is a prepreg from which a cured product, having a high glass transition temperature, a low water absorption rate, and sufficiently suppressed increases in the dielectric constant and dielectric loss tangent due to water absorption even after water absorption, is suitably obtained. Moreover, this prepreg is a prepreg from which a wiring board, having a high glass transition temperature, a low water absorption rate, and sufficiently suppressed increases in the dielectric constant and dielectric loss tangent due to water absorption even after water absorption, can be manufactured.

FIG. 2 is a schematic sectional view illustrating an example of a metal-clad laminate 11 according to an embodiment of the present invention.

As illustrated in FIG. 2, the metal-clad laminate 11 includes an insulating layer 12 containing a cured product of the prepreg 1 illustrated in FIG. 1 and a metal foil 13 to be laminated together with the insulating layer 12. In other words, the metal-clad laminate 11 includes the insulating layer 12 containing a cured product of a resin composition and the metal foil 13 provided on the insulating layer 12. In addition, the insulating layer 12 may be formed of a cured product of the resin composition or a cured product of the prepreg. In addition, the thickness of the metal foil 13 varies depending on the performance and the like to be required for the finally obtained wiring board and is not particularly limited. The thickness of the metal foil 13 can be appropriately set depending on the desired purpose and is preferably, for example, 0.2 to 70 μm. Moreover, examples of the metal foil 13 include a copper foil and an aluminum foil, and the metal foil 13 may be a copper foil with carrier which includes a release layer and a carrier for the improvement in handleability in a case where the metal foil is thin.

The method for manufacturing the metal-clad laminate 11 is not particularly limited as long as the metal-clad laminate 11 can be manufactured. Specific examples thereof include a method in which the metal-clad laminate 11 is fabricated using the prepreg 1. Examples of this method include a method in which the double-sided metal foil-clad or single-sided metal foil-clad laminate 11 is fabricated by stacking one sheet or a plurality of sheets of prepreg 1, further stacking the metal foil 13 such as a copper foil on both or one of upper and lower surfaces of the prepregs 1, and laminating and integrating the metal foils 13 and prepregs 1 by heating and pressing. In other words, the metal-clad laminate 11 is obtained by laminating the metal foil 13 on the prepreg 1 and then performing heating and pressing. Moreover, the heating and pressing conditions can be appropriately set depending on the thickness of the metal-clad laminate 11 to be manufactured, the kind of the composition of the prepreg 1, and the like. For example, it is possible to set the temperature to 170°C to 210°C, the pressure to 3.5 to 4 MPa, and the time to 60 to 150 minutes. Moreover, the metal-clad laminate may be manufactured without using a prepreg. Examples thereof include a method in which a varnish-like resin composition is applied on a metal foil to form a layer containing the resin composition on the metal foil and then heating and pressing is performed.

The resin composition according to the present embodiment is a resin composition from which a cured product, having a high glass transition temperature, a low water absorption rate, and sufficiently suppressed increases in the dielectric constant and dielectric loss tangent due to water absorption even after water absorption, is suitably obtained. For this reason, a metal-clad laminate including an insulating layer containing a cured product of this resin composition is a metal-clad laminate having a high glass transition temperature, a low water absorption rate, and sufficiently suppressed increases in the dielectric constant and dielectric loss tangent due to water absorption even after water absorption. Moreover, this metal-clad laminate is a metal-clad laminate from which a wiring board, having a high glass transition

temperature, a low water absorption rate, and sufficiently suppressed increases in the dielectric constant and dielectric loss tangent due to water absorption even after water absorption, can be manufactured.

FIG. 3 is a schematic sectional view illustrating an example of a wiring board 21 according to an embodiment of the present invention.

The wiring board 21 according to the present embodiment is formed of an insulating layer 12 obtained by curing the prepreg 1 illustrated in FIG. 1 and wiring 14 which is laminated together with the insulating layer 12 and is formed by partially removing the metal foil 13 as illustrated in FIG. 3. In other words, the wiring board 21 includes the insulating layer 12 containing a cured product of a resin composition and the wiring 14 provided on the insulating layer 12. In addition, the insulating layer 12 may be formed of a cured product of the resin composition or a cured product of the prepreg.

The method for manufacturing the wiring board 21 is not particularly limited as long as the wiring board 21 can be manufactured. Specific examples thereof include a method in which the wiring board 21 is fabricated using the prepreg 1. Examples of this method include a method in which the wiring board 21, in which wiring is provided as a circuit on the surface of the insulating layer 12, is fabricated by forming wiring through etching and the like of the metal foil 13 on the surface of the metal-clad laminate 11 fabricated in the manner described above. In other words, the wiring board 21 is obtained by partially removing the metal foil 13 on the surface of the metal-clad laminate 11 and thus forming a circuit. In addition, examples of the method for forming a circuit include circuit formation by a semi-additive process (SAP) or a modified semi-additive process (MSAP) in addition to the method described above. The wiring board 21 includes the insulating layer 12 having a high glass transition temperature, a low water absorption rate, and sufficiently suppressed increases in the dielectric constant and dielectric loss tangent due to water absorption even after water absorption.

Such a wiring board is a wiring board having a high glass transition temperature, a low water absorption rate, and sufficiently suppressed increases in the dielectric constant and dielectric loss tangent due to water absorption even after water absorption.

FIG. 4 is a schematic sectional view illustrating an example of a metal foil with resin 31 according to the present embodiment.

The metal foil with resin 31 according to the present embodiment includes a resin layer 32 containing the resin composition or a semi-cured product of the resin composition and a metal foil 13 as illustrated in FIG. 4. The metal foil with resin 31 includes the metal foil 13 on the surface of the resin layer 32. In other words, the metal foil with resin 31 includes the resin layer 32 and the metal foil 13 to be laminated together with the resin layer 32. Moreover, the metal foil with resin 31 may include other layers between the resin layer 32 and the metal foil 13.

In addition, the resin layer 32 may contain a semi-cured product of the resin composition as described above or may contain the uncured resin composition. In other words, the metal foil with resin 31 may be a metal foil with resin including a resin layer containing a semi-cured product of the resin composition (the B-stage resin composition) and a metal foil or a metal foil with resin including a resin layer containing the resin composition before being cured (the A-stage resin composition) and a metal foil. Moreover, the resin layer only needs to contain the resin composition or a semi-cured product of the resin composition and may or may not contain a fibrous base material. In addition, as the fibrous base material, those similar to the fibrous base materials of the prepreg can be used.

Moreover, as the metal foil, metal foils to be used in metal-clad laminates can be used without being limited. Examples of the metal foil include a copper foil and an aluminum foil.

The metal foil with resin 31 and a film with resin 41 may include a cover film and the like if necessary. By including the cover film, it is possible to prevent entry of foreign matter and the like. The cover film is not particularly limited, and examples thereof include a polyolefin film, a polyester film, a polymethylpentene film, and films formed by providing a release agent layer on these films.

The method for manufacturing the metal foil with resin 31 is not particularly limited as long as the metal foil with resin 31 can be manufactured. Examples of the method for manufacturing the metal foil with resin 31 include a method in which the varnish-like resin composition is applied on the metal foil 13 and heated to manufacture the metal foil with resin 31. The varnish-like resin composition is applied on the metal foil 13 using, for example, a bar coater. The applied resin composition is heated under the conditions of, for example, 80°C or more and 180°C or less and 1 minute or more and 10 minutes or less. The heated resin composition is formed as the uncured resin layer 32 on the metal foil 13.

The resin composition according to the present embodiment is a resin composition from which a cured product, having a high glass transition temperature, a low water absorption rate, and sufficiently suppressed increases in the dielectric constant and dielectric loss tangent due to water absorption even after water absorption, is suitably obtained. For this reason, a metal foil with resin including a resin layer containing this resin composition or a semi-cured product of this resin composition is a metal foil with resin from which a cured product, having a high glass transition temperature, a low water absorption rate, and sufficiently suppressed increases in the dielectric constant and dielectric loss tangent due to water absorption even after water absorption, is suitably obtained. Moreover, this metal foil with resin can be used when manufacturing a wiring board having a high glass transition temperature, a low water absorption rate, and sufficiently suppressed increases in the dielectric constant and dielectric loss tangent due to water absorption even after water absorption. For example, by laminating the metal foil with resin on a wiring board, a multilayer wiring board can

be manufactured. As a wiring board obtained using such a metal foil with resin, there is obtained a wiring board having a high glass transition temperature, a low water absorption rate, and sufficiently suppressed increases in the dielectric constant and dielectric loss tangent due to water absorption even after water absorption.

FIG. 5 is a schematic sectional view illustrating an example of a film with resin 41 according to the present embodiment.

The film with resin 41 according to the present embodiment includes a resin layer 42 containing the resin composition or a semi-cured product of the resin composition and a support film 43 as illustrated in FIG. 5. The film with resin 41 includes the resin layer 42 and the support film 43 to be laminated together with the resin layer 42. Moreover, the film with resin 41 may include other layers between the resin layer 42 and the support film 43.

In addition, the resin layer 42 may contain a semi-cured product of the resin composition as described above or may contain the uncured resin composition. In other words, the film with resin 41 may be a film with resin including a resin layer containing a semi-cured product of the resin composition (the B-stage resin composition) and a support film or a film with resin including a resin layer containing the resin composition before being cured (the A-stage resin composition) and a support film. Moreover, the resin layer only needs to contain the resin composition or a semi-cured product of the resin composition and may or may not contain a fibrous base material. In addition, as the fibrous base material, those similar to the fibrous base materials of the prepreg can be used.

Moreover, as the support film 43, support film to be used in film with resin can be used without being limited. Examples of the support film include electrically insulating films such as a polyester film, a polyethylene terephthalate (PET) film, a polyimide film, a polyparabanic acid film, a polyether ether ketone film, a polyphenylene sulfide film, a polyamide film, a polycarbonate film, and a polyarylate film.

The film with resin 41 may include a cover film and the like if necessary. By including a cover film, it is possible to prevent entry of foreign matter and the like. The cover film is not particularly limited, and examples thereof include a polyolefin film, a polyester film, and a polymethylpentene film.

The support film and the cover film may be those subjected to surface treatments such as a mud treatment, a corona treatment, a release treatment, and a roughening treatment if necessary.

The method for manufacturing the film with resin 41 is not particularly limited as long as the film with resin 41 can be manufactured. Examples of the method for manufacturing the film with resin 41 include a method in which the varnish-like resin composition is applied on the support film 43 and heated to manufacture the film with resin 41. The varnish-like resin composition is applied on the support film 43 using, for example, a bar coater. The applied resin composition is heated under the conditions of, for example, 80°C or more and 180°C or less and 1 minute or more and 10 minutes or less. The heated resin composition is formed as the uncured resin layer 42 on the support film 43.

The resin composition according to the present embodiment is a resin composition from which a cured product, having a high glass transition temperature, a low water absorption rate, and sufficiently suppressed increases in the dielectric constant and dielectric loss tangent due to water absorption even after water absorption, is suitably obtained. For this reason, a film with resin including a resin layer containing this resin composition or a semi-cured product of this resin composition is a film with resin from which a cured product, having a high glass transition temperature, a low water absorption rate, and sufficiently suppressed increases in the dielectric constant and dielectric loss tangent due to water absorption even after water absorption, is suitably obtained. Moreover, this film with resin can be used when manufacturing a wiring board having a high glass transition temperature, a low water absorption rate, and sufficiently suppressed increases in the dielectric constant and dielectric loss tangent due to water absorption even after water absorption. A multilayer wiring board can be manufactured, for example, by laminating the film with resin on a wiring board and then peeling off the support film from the film with resin or by peeling off the support film from the film with resin and then laminating the film with resin on a wiring board. As a wiring board obtained using such a film with resin, there is obtained a wiring board having a high glass transition temperature, a low water absorption rate, and sufficiently suppressed increases in the dielectric constant and dielectric loss tangent due to water absorption even after water absorption.

The present specification discloses various aspects of a technique as described above, but the main technique is summarized below.

An aspect of the present invention is a resin composition comprising a maleimide compound represented by the following Formula (1), a modified polyphenylene ether compound of which a terminal is modified with a substituent having a carbon-carbon unsaturated double bond, and a crosslinking agent containing an allyl compound.

[Chem. 15]

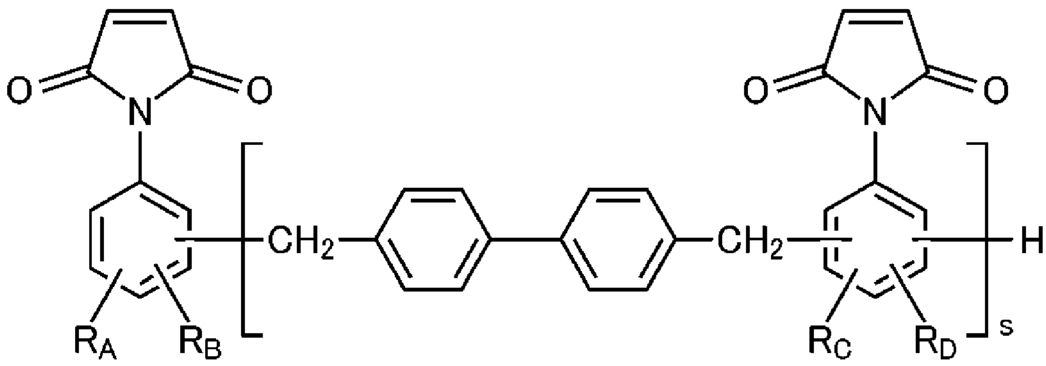

(1)

In Formula (1), s represents 1 to 5 and $R_A$, $R_B$, $R_C$, and $R_D$ each independently represent a hydrogen atom, an alkyl group having 1 to 5 carbon atoms, or a phenyl group.

According to such a configuration, it is possible to provide a resin composition from which a cured product, having a high glass transition temperature, a low water absorption rate, and sufficiently suppressed increases in the dielectric constant and dielectric loss tangent due to water absorption even after water absorption, is suitably obtained.

This is considered to be due to the following.

First, it is considered that a cured product which maintains the excellent low dielectric properties of polyphenylene ether is obtained from the resin composition by crosslinking the modified polyphenylene ether compound with the maleimide compound and the crosslinking agent.

In addition, the glass transition temperature tends to increase when a maleimide compound is contained in the resin composition. On the other hand, when a maleimide compound is contained in the resin composition, a cured product of the resin composition tends to have an increased water absorption rate and further decreased dielectric constant and dielectric loss tangent after water absorption. In contrast, in the case of containing a maleimide compound represented by Formula (1) among maleimide compounds, not only the glass transition temperature can be increased but also increases in the dielectric constant and dielectric loss tangent due to water absorption can be sufficiently suppressed even after water absorption while sufficiently suppressing an increase in the water absorption rate.

In addition, when a maleimide compound is contained in a resin composition containing a modified polyphenylene ether compound, there is a tendency that the compatibility of the maleimide compound with the resin composition containing a modified polyphenylene ether compound is low and a suitable varnish is not obtained when the obtained resin composition is formed into a varnish. This is considered to be because the maleimide compound exhibits low solubility in the solvent used when the varnish is formed. In contrast, when a maleimide compound represented by Formula (1) is used as the maleimide compound and further a crosslinking agent containing an allyl compound is used as the crosslinking agent, the compatibility between the resin composition containing a modified polyphenylene ether compound and the maleimide compound is enhanced and a varnish is suitably obtained. This is considered to be because the maleimide compound exhibits high solubility in the solvent used when the varnish is formed and the allyl compound enhances the compatibility between the modified polyphenylene ether compound and the maleimide compound represented by Formula (1).

As described above, it is considered that a cured product, having a high glass transition temperature, a low water absorption rate, and sufficiently suppressed increases in the dielectric constant and dielectric loss tangent due to water absorption even after water absorption, is suitably obtained from the resin composition having the above configuration.

Moreover, in the resin composition, it is preferable that the crosslinking agent further contains at least one of a polyfunctional acrylate compound having two or more acryloyl groups in the molecule and a polyfunctional methacrylate compound having two or more methacryloyl groups in the molecule, and it is more preferable that the polyfunctional methacrylate compound contains a dimethacrylate compound.

According to such a configuration, it is possible to provide a resin composition from which a cured product, having a higher glass transition temperature, a low water absorption rate, and further suppressed increases in the dielectric constant and dielectric loss tangent due to water absorption even after water absorption, is suitably obtained.

This is considered to be because the glass transition temperature is further increased by use of a crosslinking agent containing not only an allyl compound but also a dimethacrylate compound exhibiting lower volatility than the allyl compound as a crosslinking agent. Moreover, it is considered that the moldability is also enhanced by containing a dimethacrylate compound exhibiting relatively low volatility as a crosslinking agent.

Moreover, in the resin composition, it is preferable that the allyl compound contains at least one of triallyl

isocyanurate and diallyl bisphenol.

According to such a configuration, it is possible to provide a resin composition from which a cured product, having a higher glass transition temperature, a low water absorption rate, and further suppressed increases in the dielectric constant and dielectric loss tangent due to water absorption even after water absorption, is suitably obtained.

Moreover, in the resin composition, the content of the maleimide compound is 10 to 60 parts by mass with respect to 100 parts by mass of the total mass of the maleimide compound, the modified polyphenylene ether compound, and the crosslinking agent.

According to such a configuration, it is possible to provide a resin composition from which a cured product, having a higher glass transition temperature, a low water absorption rate, and further suppressed increases in the dielectric constant and dielectric loss tangent due to water absorption even after water absorption, is suitably obtained.

This is considered to be because the effect by the addition of a maleimide compound represented by Formula (1) is more suitably exerted.

Moreover, in the resin composition, it is preferable that the content of the modified polyphenylene ether compound is 10 to 75 parts by mass with respect to 100 parts by mass of the total mass of the maleimide compound, the modified polyphenylene ether compound, and the crosslinking agent.

According to such a configuration, it is possible to provide a resin composition from which a cured product, having a higher glass transition temperature, a low water absorption rate, and further suppressed increases in the dielectric constant and dielectric loss tangent due to water absorption even after water absorption, is suitably obtained.

This is considered to be because the effect by the addition of a maleimide compound represented by Formula (1) is more suitably exerted.

Moreover, in the resin composition, it is preferable that an inorganic filler treated in advance with a silane coupling agent is further contained.

According to such a configuration, it is possible to provide a resin composition from which a cured product, having a higher glass transition temperature, a low water absorption rate, and further suppressed increases in the dielectric constant and dielectric loss tangent due to water absorption even after water absorption, is suitably obtained.

In addition, another aspect of the present invention is a prepreg comprising the resin composition or a semi-cured product of the resin composition, and a fibrous base material.

According to such a configuration, it is possible to provide a prepreg from which a cured product, having a high glass transition temperature, a low water absorption rate, and sufficiently suppressed increases in the dielectric constant and dielectric loss tangent due to water absorption even after water absorption, is suitably obtained.

In addition, another aspect of the present invention is a film with resin comprising a resin layer containing the resin composition or a semi-cured product of the resin composition, and a support film.

According to such a configuration, it is possible to provide a film with resin having a high glass transition temperature, a low water absorption rate, and sufficiently suppressed increases in the dielectric constant and dielectric loss tangent due to water absorption even after water absorption.

In addition, another aspect of the present invention is a metal foil with resin comprising a resin layer containing the resin composition or a semi-cured product of the resin composition, and a metal foil.

According to such a configuration, it is possible to provide a metal foil with resin having a high glass transition temperature, a low water absorption rate, and sufficiently suppressed increases in the dielectric constant and dielectric loss tangent due to water absorption even after water absorption.

In addition, another aspect of the present invention is a metal-clad laminate comprising an insulating layer containing a cured product of the resin composition or a cured product of the prepreg, and a metal foil.

According to such a configuration, it is possible to provide a metal-clad laminate having a high glass transition temperature, a low water absorption rate, and sufficiently suppressed increases in the dielectric constant and dielectric loss tangent due to water absorption even after water absorption.

In addition, another aspect of the present invention is a wiring board comprising an insulating layer containing a cured product of the resin composition or a cured product of the prepreg, and wiring.

According to such a configuration, it is possible to provide a wiring board having a high glass transition temperature, a low water absorption rate, and sufficiently suppressed increases in the dielectric constant and dielectric loss tangent due to water absorption even after water absorption.

According to the present invention, it is possible to provide a resin composition from which a cured product, having a high glass transition temperature, a low water absorption rate, and sufficiently suppressed increases in the dielectric constant and dielectric loss tangent due to water absorption even after water absorption, is suitably obtained. In addition, according to the present invention, a prepreg, a film with resin, a metal foil with resin, a metal-clad laminate, and a wiring board which are obtained using the resin composition are provided.

Hereinafter, the present invention will be described more specifically with reference to examples, but the scope of the present invention is not limited thereto.

## Examples

[Examples 1 to 6 and Comparative Examples 1 to 5]

The respective components to be used when preparing a resin composition in the present examples will be described.

(Maleimide compound)

MIR-3000-70MT: Maleimide compound represented by Formula (1), where $R_A$, $R_B$, $R_C$, and $R_D$ in Formula (1) are a hydrogen atom (MIR-3000-70MT manufactured by Nippon Kayaku Co., Ltd.)
BMI-2300: Polyphenylmethanemaleimide (BMI2300 manufactured by Daiwa Kasei Industry Co., Ltd.)
BMI-4000: Bisphenol A type biphenyl ether bismaleimide (BMI4000 manufactured by Daiwa Kasei Industry Co., Ltd.)
BMI-5100: 3,3-Dimethyl-5,5'-diethyl-4,4'-diphenylmethanebismaleimide (BMI5100 manufactured by Daiwa Kasei Industry Co., Ltd.)

(Modified polyphenylene ether compound: modified PPE)

Modified PPE-1: Modified polyphenylene ether compound having a vinylbenzyl group (ethenylbenzyl group) at the terminal (OPE-2st 1200 manufactured by MITSUBISHI GAS CHEMICAL COMPANY, INC., a modified polyphenylene ether compound which has Mn of 1200 and is represented by Formula (11), where Z is a phenylene group, $R_1$ to $R_3$ are a hydrogen atom, and p is 0)
Modified PPE-2: Modified polyphenylene ether obtained by reacting polyphenylene ether with chloromethylstyrene.

Specifically, this is a modified polyphenylene ether obtained by conducting reaction as follows.

First, 200 g of polyphenylene ether (SA90 manufactured by SABIC Innovative Plastics IP BV, number of terminal hydroxyl groups: 2, weight average molecular weight Mw: 1700), 30 g of a mixture containing p-chloromethylstyrene and m-chloromethylstyrene at a mass ratio of 50 : 50 (chloromethylstyrene: CMS manufactured by Tokyo Chemical Industry Co., Ltd.), 1.227 g of tetra-n-butylammonium bromide as a phase transfer catalyst, and 400 g of toluene were introduced into a 1-liter three-necked flask including a temperature controller, a stirrer, cooling equipment, and a dropping funnel and stirred. Moreover, the mixture was stirred until polyphenylene ether, chloromethylstyrene, and tetra-n-butylammonium bromide were dissolved in toluene. At that time, the mixture was gradually heated until the liquid temperature finally reached 75°C. Thereafter, an aqueous sodium hydroxide solution (20 g of sodium hydroxide/20 g of water) as an alkali metal hydroxide was added dropwise to the solution over 20 minutes. Thereafter, the mixture was further stirred at 75°C for 4 hours. Next, the resultant in the flask was neutralized with hydrochloric acid at 10% by mass and then a large amount of methanol was added into the flask. By doing so, a precipitate was generated in the liquid in the flask. In other words, the product contained in the reaction solution in the flask was reprecipitated. Thereafter, this precipitate was taken out by filtration, washed three times with a mixed solution of methanol and water contained at a mass ratio of 80 : 20, and then dried under reduced pressure at 80°C for 3 hours.

The obtained solid was analyzed by $^1$H-NMR (400 MHz, $CDCl_3$, TMS). As a result of NMR measurement, a peak attributed to a vinylbenzyl group (ethenylbenzyl group) was observed at 5 to 7 ppm. This made it possible to confirm that the obtained solid was a modified polyphenylene ether having a vinylbenzyl group (ethenylbenzyl group) as a substituent at the molecular terminal in the molecule. Specifically, it was confirmed that the solid obtained was ethenylbenzylated polyphenylene ether. The obtained modified polyphenylene ether compound was a modified polyphenylene ether compound represented by Formula (12), where Y was a dimethylmethylene group (represented by Formula (10), where $R_{33}$ and $R_{34}$ in Formula (10) were a methyl group), Z was a phenylene group, $R_1$ to $R_3$ were a hydrogen atom, and p was 0.

In addition, the number of terminal functional groups in the modified polyphenylene ether was measured as follows.

First, the modified polyphenylene ether was accurately weighed. The weight at that time is defined as X (mg). Thereafter, this modified polyphenylene ether weighed was dissolved in 25 mL of methylene chloride, 100 μL of an ethanol solution of tetraethylammonium hydroxide (TEAH) at 10% by mass (TEAH : ethanol (volume ratio) = 15 : 85) was added to the solution, and then the absorbance (Abs) of this mixture at 318 nm was measured using a UV spectrophotometer (UV-1600 manufactured by Shimadzu Corporation). Thereafter, the number of terminal hydroxyl groups

in the modified polyphenylene ether was calculated from the measurement result using the following equation.

$$\text{Residual OH amount } (\mu\text{mol/g}) = [(25 \times \text{Abs})/(\varepsilon \times \text{OPL} \times \text{X})] \times 10^6$$

Here, ε indicates the extinction coefficient and is 4700 L/mol·cm. In addition, OPL indicates the cell path length and is 1 cm.

Moreover, since the calculated residual OH amount (the number of terminal hydroxyl groups) in the modified polyphenylene ether is almost zero, it was found that the hydroxyl groups in the polyphenylene ether before being modified are almost modified. Thus, it was found that the number of terminal hydroxyl groups decreased from the number of terminal hydroxyl groups in polyphenylene ether before being modified is the number of terminal hydroxyl groups in polyphenylene ether before being modified. In other words, it was found that the number of terminal hydroxyl groups in polyphenylene ether before being modified is the number of terminal hydroxyl groups in the modified polyphenylene ether. In other words, the number of terminal functional groups was two.

In addition, the intrinsic viscosity (IV) of the modified polyphenylene ether was measured in methylene chloride at 25°C. Specifically, the intrinsic viscosity (IV) of the modified polyphenylene ether was measured in a methylene chloride solution (liquid temperature: 25°C) of the modified polyphenylene ether at 0.18 g/45 ml using a viscometer (AVS500 Visco System manufactured by SCHOTT Instruments GmbHt). As a result, the intrinsic viscosity (IV) of the modified polyphenylene ether was 0.086 dl/g.

In addition, the molecular weight distribution of the modified polyphenylene ether was measured by GPC. Moreover, the weight average molecular weight (Mw) was calculated from the obtained molecular weight distribution. As a result, Mw was 1,900.

(Crosslinking agent: allyl compound)

TAIC: Triallyl isocyanurate (TAIC manufactured by Nihon Kasei CO., LTD.)
DABPA: 2,2'-Diallylbisphenol A (2,2'-diallyl-4,4'-isopropylidene diphenol, DABPA manufactured by Daiwa Kasei Industry Co., Ltd.)

(Crosslinking agent: dimethacrylate compound)

DCP: Tricyclodecane dimethanol dimethacrylate (NK Ester DCP manufactured by Shin-Nakamura Chemical Co., Ltd.)

(Initiator)

Perbutyl P: 1,3-Di(t-butylperoxyisopropyl)benzene (Perbutyl P manufactured by NOF Corporation)

(Silane coupling agent)

KBM-503: Silane coupling agent having a methacryloyl group in the molecule (3-methacryloxypropyltrimethoxysilane, KBM-503 manufactured by Shin-Etsu Chemical Co., Ltd.)

(Filler)

SC2500-SXJ: Silica particles subjected to a surface treatment with a silane coupling agent having a phenylamino group in the molecule (SC2500-SXJ manufactured by Admatechs Company Limited)

(Preparation method)

First, the respective components other than the filler were added to and mixed in methyl ethyl ketone (MEK) at the composition (parts by mass) shown in Table 1 so that the solid concentration was 70% by mass. The mixture was stirred for 60 minutes. Thereafter, the filler was added to and dispersed in the obtained liquid using a bead mill. By doing so, a varnish-like resin composition (varnish) was obtained.

Next, the obtained varnish was impregnated into a fibrous base material (glass cloth: #1080 type, E Glass

manufactured by Asahi Kasei Corporation) and then heated and dried at 130°C for about 3 to 8 minutes, thereby fabricating a prepreg. At that time, the content (resin content) of the components constituting the resin by the curing reaction, such as a maleimide compound, modified polyphenylene ether, and a crosslinking agent, with respect to the prepreg was adjusted to be about 70% by mass.

Thereafter, eight sheets of each obtained prepreg were stacked and heated to a temperature of 220°C at a rate of temperature rise of 4°C/min and heated and pressed under the conditions of 220°C, 90 minutes, and a pressure of 4 MPa, thereby obtaining an evaluation substrate (cured product of prepreg).

The varnish, prepreg, and evaluation substrate prepared in the manner described above were evaluated by the following methods.

[Compatibility]

Each varnish was visually observed. As a result, the resin composition was evaluated as "Very Good" when it was transparent, and the resin composition was evaluated as "Good" when it could be fabricated into a varnish but turbidity was observed. The resin composition was evaluated as "Poor" when it could not be fabricated into a varnish. Thereafter, a prepreg could not be fabricated using this resin composition and thus evaluation on those other than compatibility could not be performed and the evaluation results are shown as "-" in Table 1.

[Glass transition temperature (Tg)]

The Tg of the prepreg was measured using a viscoelastic spectrometer "DMS6100" manufactured by Seiko Instruments Inc. At this time, a dynamic viscoelasticity measurement (DMA) was performed at a bending module by setting the frequency to 10 Hz, and the temperature at which tan $\delta$ was the maximum when the temperature was raised from room temperature to 320°C under the condition of a rate of temperature rise of 5°C/min was defined as Tg.

[Peel strength]

The copper foil was peeled off from the evaluation substrate, and the peel strength at that time was measured in conformity with JIS C6481. Specifically, the insulating layer (prepreg) on the uppermost surface of the evaluation substrate was peeled off at a speed of 50 mm/min using a tensile tester, and the peel strength (N/mm) at that time was measured.

[Water absorption rate]

The water absorption rate (%) of the evaluation substrate was measured by a method conforming to IPC-TM-650 2.6.2.1.

[Dielectric properties (relative dielectric constant and dielectric loss tangent)]

The relative dielectric constant and dielectric loss tangent of the evaluation substrate at 1 GHz were measured by a method conforming to IPC-TM650-2.5.5.9. Specifically, the relative dielectric constant and dielectric loss tangent of the evaluation substrate at 1 GHz were measured using an impedance analyzer (RF Impedance Analyzer HP4291B manufactured by Agilent Technologies, Inc.). The relative dielectric constant and dielectric loss tangent were measured before and after the evaluation substrate absorbed water.

In addition, the difference between the relative dielectric constant after water absorption and the relative dielectric constant before water absorption and the difference between the dielectric loss tangent after water absorption and the dielectric loss tangent before water absorption were calculated.

The results of the respective evaluations are shown in Table 1.

[Table 1]

| | | | | Example | | | | | | Comparative Example | | | | |
|---|---|---|---|---|---|---|---|---|---|---|---|---|---|---|
| | | | | 1 | 2 | 3 | 4 | 5 | 6 | 1 | 2 | 3 | 4 | 5 |
| Composition (parts by mass) | Maleimide compound | MIR-3000-70MT | | 30 | 30 | 30 | 10 | 60 | 30 | 0 | 0 | 0 | 70 | 0 |
| | | BMI-2300 | | 0 | 0 | 0 | 0 | 0 | 0 | 30 | 0 | 0 | 0 | 0 |
| | | BMI-4000 | | 0 | 0 | 0 | 0 | 0 | 0 | 0 | 30 | 0 | 0 | 0 |
| | | BMI-5100 | | 0 | 0 | 0 | 0 | 0 | 0 | 0 | 0 | 30 | 0 | 0 |
| | Modified PPE | Modified PPE-1 | | 40 | 40 | 0 | 75 | 10 | 40 | 40 | 40 | 40 | 0 | 70 |
| | | Modified PPE-2 | | 0 | 0 | 40 | 0 | 0 | 0 | 0 | 0 | 0 | 0 | 0 |
| | Crosslinking agent | Allyl compound | TAIC | 10 | 30 | 10 | 5 | 10 | 15 | 10 | 10 | 10 | 10 | 10 |
| | | | DABPA | 10 | 0 | 10 | 5 | 10 | 0 | 10 | 10 | 10 | 10 | 10 |
| | | Dimethacrylate compound | DCP | 10 | 0 | 10 | 5 | 10 | 15 | 10 | 10 | 10 | 10 | 10 |
| | Initiator | Perbutyl P | | 1 | 1 | 1 | 1 | 1 | 1 | 1 | 1 | 1 | 1 | 1 |
| | Silane coupling agent | | KBM-503 | 2 | 2 | 2 | 2 | 2 | 2 | 2 | 2 | 2 | 2 | 2 |
| | Filler | SC2500-SXJ | | 125 | 125 | 125 | 125 | 125 | 125 | 125 | 125 | 125 | 125 | 125 |

(continued)

| | | | Example | | | | | | Comparative Example | | | | |
|---|---|---|---|---|---|---|---|---|---|---|---|---|---|
| | | | 1 | 2 | 3 | 4 | 5 | 6 | 1 | 2 | 3 | 4 | 5 |
| Evaluation | Compatibility (varnish) | | Very Good | Very Good | Very Good | Very Good | Very Good | Very Good | Good | Poor | Poor | Very Good | Very Good |
| | Tg(°C) | | 295 | 268 | 308 | 248 | >320 | 304 | >320 | - | - | >320 | 216 |
| | Peel strength (N/m) | | 0.72 | 0.76 | 0.89 | 0.81 | 0.99 | 0.71 | 0.74 | - | - | 1.06 | 0.83 |
| | Water absorption rate (%) | | 0.39 | 0.38 | 0.45 | 0.22 | 0.49 | 0.38 | 0.59 | - | - | 0.66 | 0.18 |
| | Before water absorption | Relative dielectric constant | 3.58 | 3.59 | 3.59 | 3.51 | 3.63 | 3.52 | 3.61 | - | - | 3.79 | 3.57 |
| | | Dielectric loss tangent | 0.0035 | 0.0023 | 0.0027 | 0.0027 | 0.0027 | 0.0029 | 0.0035 | - | - | 0.0022 | 0.0032 |
| | After water absorption | Relative dielectric constant | 3.70 | 3.72 | 3.67 | 3.59 | 3.80 | 3.65 | 3.80 | - | - | 3.98 | 3.59 |
| | | Dielectric loss tangent | 0.0059 | 0.0046 | 0.0054 | 0.0042 | 0.0058 | 0.0051 | 0.0074 | - | - | 0.0063 | 0.0044 |
| | Amount of change in relative dielectric constant (after water absorption - before water absorption) | | 0.12 | 0.13 | 0.08 | 0.08 | 0.17 | 0.13 | 0.19 | - | - | 0.19 | 0.02 |
| | Amount of change in dielectric loss tangent (after water absorption - before water absorption) | | 0.0024 | 0.0023 | 0.0027 | 0.0015 | 0.0031 | 0.0022 | 0.0039 | - | - | 0.0041 | 0.0012 |

From Table 1, it can be seen that in the case of resin compositions containing a maleimide compound represented by Formula (1), the modified polyphenylene ether compound, and an allyl compound as a crosslinking agent (Examples 1 to 6), the glass transition temperature is high, cured products of the resin compositions have a low water absorption, and increases in the relative dielectric constant and dielectric loss tangent of the cured products due to water absorption can be sufficiently suppressed even after water absorption. In contrast, in a case where a maleimide compound other than the maleimide compound represented by Formula (1) was contained (Comparative Examples 1 to 3), the compatibility was deteriorated and a suitable varnish could not be obtained. Even when a varnish was obtained (Comparative Example 1), the water absorption of a cured product thereof was high and further the relative dielectric constant and dielectric loss tangent of the cured product after water absorption greatly increased. In addition, in a case where the modified polyphenylene ether was not contained (Comparative Example 4), the water absorption of a cured product of the varnish was high and further the relative dielectric constant and dielectric loss tangent after water absorption greatly increased. In addition, in a case where a maleimide compound was not contained (Comparative Example 5), the glass transition temperature was low.

In addition, in the case of containing not only an allyl compound but also a dimethacrylate compound as a crosslinking agent (Examples 1 and 6), the glass transition temperature was higher although the total amount of the crosslinking agent was the same as in the case of containing only an allyl compound as a crosslinking agent (Example 2). Thus, it was found that it is preferable to concurrently use an allyl compound and a dimethacrylate compound instead of using only an allyl compound as a crosslinking agent. Furthermore, in the case of containing not only an allyl compound but also a dimethacrylate compound as a crosslinking agent, deterioration in resin flowability of the resin composition when the resin composition was stored at 40°C was suppressed in the case of using only TAIC (Example 6) than in the case of concurrently using TAIC and DABPA (Example 1) as the allyl compound. Thus, it can be seen that, as an allyl compound, it is preferable that the content of TAIC with respect to DABPA is higher, and it is more preferable that it is composed only of TAIC.

This application is based on Japanese Patent Application No. 2017-253159 filed on December 28, 2017, the contents of which are included in the present application.

In order to express the present invention, the present invention has been described above appropriately and sufficiently through the embodiments. However, it should be recognized by those skilled in the art that changes and/or improvements of the above-described embodiments can be readily made. Accordingly, changes or improvements made by those skilled in the art shall be construed as being included in the scope of the claims unless otherwise the changes or improvements are at the level which departs from the scope of the appended claims.

## Industrial Applicability

According to the present invention, a resin composition is provided from which a cured product, having a high glass transition temperature, a low water absorption rate, and sufficiently suppressed increases in the dielectric constant and dielectric loss tangent due to water absorption even after water absorption, is suitably obtained. In addition, according to the present invention, a prepreg, a film with resin, a metal foil with resin, a metal-clad laminate, and a wiring board which are obtained using the resin composition are provided.

## Claims

**1.** A resin composition comprising:

a maleimide compound represented by the following Formula (1);
a modified polyphenylene ether compound of which a terminal is modified with a substituent having a carbon-carbon unsaturated double bond; and
a crosslinking agent containing an allyl compound,
wherein a content of the maleimide compound is 10 to 60 parts by mass with respect to 100 parts by mass of a total mass of the maleimide compound, the modified polyphenylene ether compound, and the crosslinking agent,

[Chem. 1]

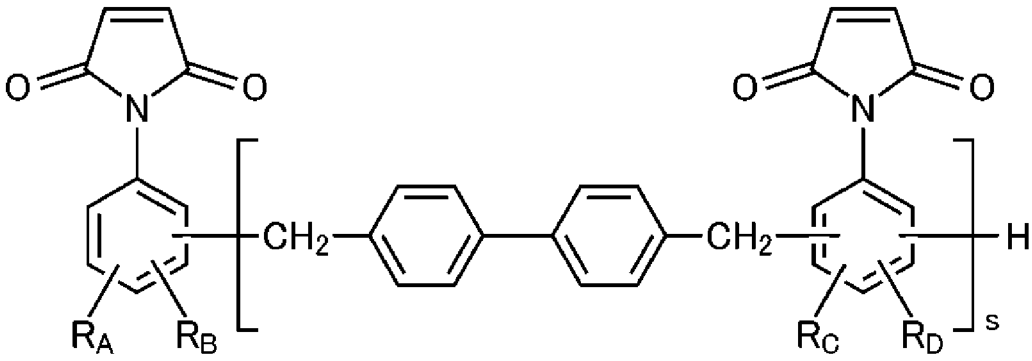

(1)

(in Formula (1), s represents 1 to 5 and $R_A$, $R_B$, Rc, and $R_D$ each independently represent a hydrogen atom, an alkyl group having 1 to 5 carbon atoms, or a phenyl group).

**2.** The resin composition according to claim 1, wherein the crosslinking agent further includes at least one of a polyfunctional acrylate compound having two or more acryloyl groups in a molecule and a polyfunctional methacrylate compound having two or more methacryloyl groups in a molecule.

**3.** The resin composition according to claim 2, wherein the polyfunctional methacrylate compound includes a dimethacrylate compound.

**4.** The resin composition according to any one of claims 1 to 3, wherein the allyl compound includes at least one of triallyl isocyanurate and diallyl bisphenol.

**5.** The resin composition according to any one of claims 1 to 4, wherein a content of the modified polyphenylene ether compound is 10 to 75 parts by mass with respect to 100 parts by mass of a total mass of the maleimide compound, the modified polyphenylene ether compound, and the crosslinking agent.

**6.** The resin composition according to any one of claims 1 to 5, further comprising an inorganic filler treated in advance with a silane coupling agent.

**7.** A prepreg comprising:

the resin composition according to any one of claims 1 to 6 or a semi-cured product of the resin composition; and
a fibrous base material.

**8.** A film with resin comprising:

a resin layer containing the resin composition according to any one of claims 1 to 6 or a semi-cured product of the resin composition; and
a support film.

**9.** A metal foil with resin comprising:

a resin layer containing the resin composition according to any one of claims 1 to 6 or a semi-cured product of the resin composition; and
a metal foil.

**10.** A metal-clad laminate comprising:

an insulating layer containing a cured product of the resin composition according to any one of claims 1 to 6 or a cured product of the prepreg according to claim 7; and
a metal foil.

**11.** A wiring board comprising:

an insulating layer containing a cured product of the resin composition according to any one of claims 1 to 6 or a cured product of the prepreg according to claim 7; and
wiring.

**Patentansprüche**

**1.** Harzzusammensetzung, umfassend:

eine Maleinimidverbindung, dargestellt durch die folgende Formel (1);
eine modifizierte Polyphenylenetherverbindung, bei der ein Ende mit einem Substituenten modifiziert ist, der eine ungesättigte Kohlenstoff-Kohlenstoff-Doppelbindung aufweist; und
ein Vernetzungsmittel, das eine Allylverbindung enthält,
wobei der Gehalt der Maleinimidverbindung, bezogen auf 100 Massenanteile der Gesamtmasse der Maleinimidverbindung, der modifizierten Polyphenylenetherverbindung und des Vernetzungsmittels, 10 bis 60 Massenanteile beträgt,

[Chem. 1]

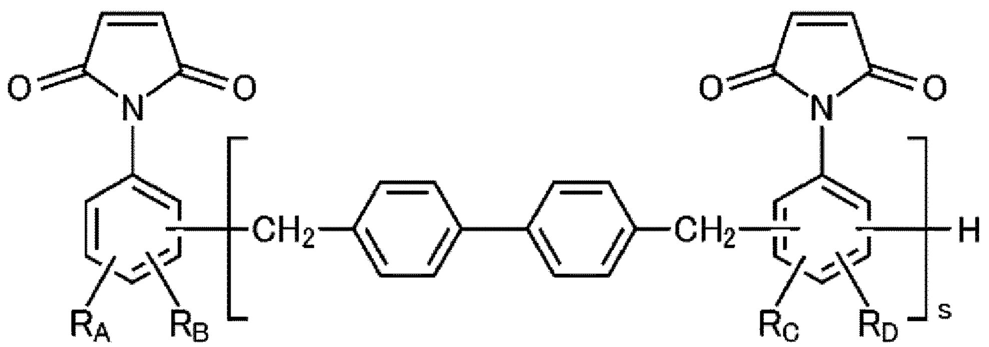

(1)

(in Formel (1) bedeutet s 1 bis 5 und $R_A$, $R_B$, $R_C$ und $R_D$ bedeuten jeweils unabhängig voneinander ein Wasserstoffatom, eine Alkylgruppe mit 1 bis 5 Kohlenstoffatomen oder eine Phenylgruppe).

**2.** Harzzusammensetzung nach Anspruch 1, wobei das Vernetzungsmittel ferner mindestens eine polyfunktionelle Acrylatverbindung mit zwei oder mehr Acryloylgruppen in einem Molekül und eine polyfunktionelle Methacrylatverbindung enthält, die zwei oder mehr Methacryloylgruppen in einem Molekül aufweist.

**3.** Harzzusammensetzung nach Anspruch 2, wobei die polyfunktionelle Methacrylatverbindung eine Dimethacrylatverbindung enthält.

**4.** Harzzusammensetzung nach einem der Ansprüche 1 bis 3, wobei die Allylverbindung mindestens eine der Verbindungen Triallylisocyanurat und Diallylbisphenol enthält.

**5.** Harzzusammensetzung nach einem der Ansprüche 1 bis 4, wobei der Gehalt an der modifizierten Polyphenylenetherverbindung bezogen auf 100 Massenanteile der Gesamtmasse der Maleinimidverbindung, der modifizierten Polyphenylenetherverbindung und des Vernetzungsmittels, 10 bis 75 Massenanteile beträgt.

**6.** Harzzusammensetzung nach einem der Ansprüche 1 bis 5, ferner einen anorganischen Füllstoff umfassend, der zuvor mit einem Silan-Haftvermittler behandelt wurde.

**7.** Prepreg, umfassend:

die Harzzusammensetzung nach einem der Ansprüche 1 bis 6 oder ein halbgehärtetes Produkt aus der Harzzusammensetzung; und
ein faseriges Grundmaterial.

**8.** Harz enthaltender Film, umfassend:

eine Harzschicht, die die Harzzusammensetzung nach einem der Ansprüche 1 bis 6 oder ein halbgehärtetes Produkt der Harzzusammensetzung enthält, und
einen Trägerfilm.

**9.** Harz enthaltende Metallfolie, umfassend:

eine Harzschicht, die die Harzzusammensetzung nach einem der Ansprüche 1 bis 6 oder ein halbgehärtetes Produkt der Harzzusammensetzung enthält, und
eine Metallfolie.

**10.** Metallkaschiertes Laminat, umfassend:

eine Isolierschicht, die ein gehärtetes Produkt der Harzzusammensetzung nach einem der Ansprüche 1 bis 6 oder ein gehärtetes Produkt des Prepregs nach Anspruch 7 enthält; und
eine Metallfolie.

**11.** Leiterplatte, umfassend:

eine Isolierschicht, die ein gehärtetes Produkt der Harzzusammensetzung nach einem der Ansprüche 1 bis 6 oder ein gehärtetes Produkt des Prepregs nach Anspruch 7 enthält; und
Verdrahtung.

**Revendications**

**1.** Composition de résine comprenant :

un composé maléimide représenté par la formule (1) qui suit ;
un composé polyphénylène-éther modifié dont une extrémité est modifiée par un substituant ayant une double liaison insaturée carbone-carbone ; et
un agent de réticulation contenant un composé allylique,
dans laquelle la teneur en le composé maléimide est de 10 à 60 parties en masse pour 100 parties en masse de la masse totale du composé maléimide, du composé polyphénylène-éther modifié, et de l'agent de réticulation,

[formule chimique 1]

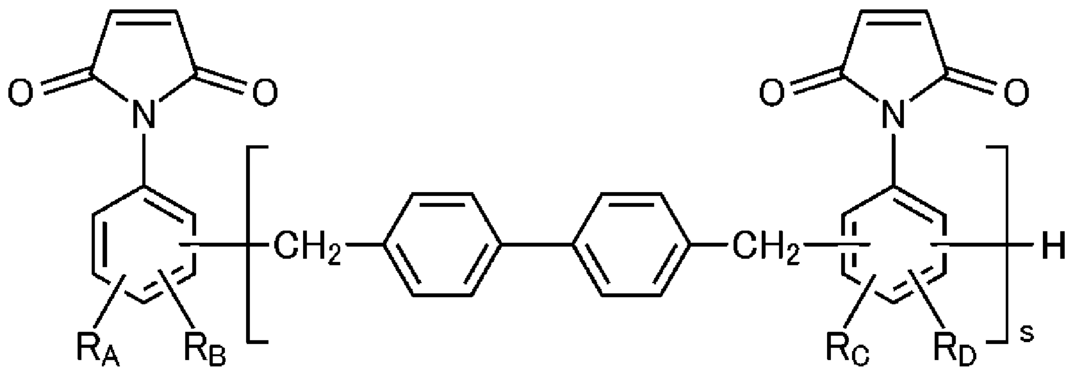

(1)

(dans la formule (1), s vaut de 1 à 5, et chacun de $R_A$, $R_B$, $R_C$ et $R_D$ représente indépendamment un atome d'hydrogène, un groupe alkyle ayant 1 à 5 atomes de carbone, ou un groupe phényle).

**2.** Composition de résine selon la revendication 1, dans laquelle l'agent de réticulation comprend en outre au moins

l'un parmi un composé acrylate polyfonctionnel ayant deux ou plus de deux groupes acryloyle par molécule et un composé méthacrylate polyfonctionnel ayant deux ou plus de deux groupes méthacryloyle par molécule.

**3.** Composition de résine selon la revendication 2, dans laquelle le composé méthacrylate polyfonctionnel comprend un composé diméthacrylate.

**4.** Composition de résine selon l'une quelconque des revendications 1 à 3, dans laquelle le composé allyle comprend au moins l'un parmi l'isocyanurate de triallyle et le diallyl-bisphénol.

**5.** Composition de résine selon l'une quelconque des revendications 1 à 4, dans laquelle la teneur en le composé polyphénylène-éther modifié est de 10 à 75 parties en masse pour 100 parties en masse de la masse totale du composé maléimide, du composé polyphénylène-éther modifié, et de l'agent de réticulation.

**6.** Composition de résine selon l'une quelconque des revendications 1 à 5, comprenant en outre une charge inorganique traitée à l'avance avec un agent de couplage au silane.

**7.** Préimprégné comprenant :

la composition de résine selon l'une quelconque des revendications 1 à 6 ou un produit semi-durci de la composition de résine ; et
un matériau de base fibreux.

**8.** Film avec résine comprenant :

une couche de résine contenant la composition de résine selon l'une quelconque des revendications 1 à 6 ou un produit semi-durci de la composition de résine ; et
un film de support.

**9.** Feuille métallique avec résine comprenant :

une couche de résine contenant la composition de résine selon l'une quelconque des revendications 1 à 6 ou un produit semi-durci de la composition de résine ; et
une feuille métallique.

**10.** Stratifié métallisé comprenant :

une couche isolante contenant un produit durci de la composition de résine selon l'une quelconque des revendications 1 à 6 ou un produit semi-durci du préimprégné selon la revendication 7 ; et
une feuille métallique.

**11.** Tableau de connexions comprenant :

une couche isolante contenant un produit durci de la composition de résine selon l'une quelconque des revendications 1 à 6 ou un produit semi-durci du préimprégné selon la revendication 7 ; et
un câblage.

FIG. 1

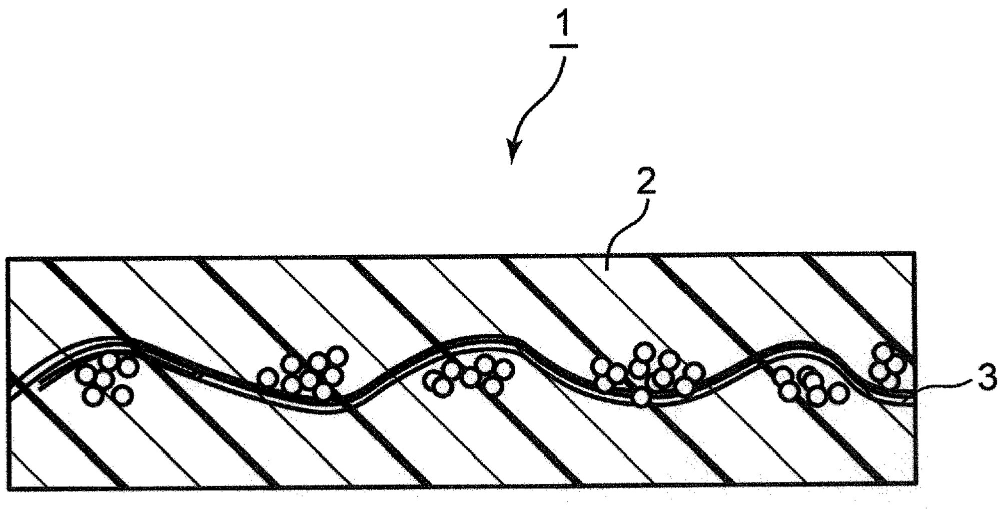

FIG. 2

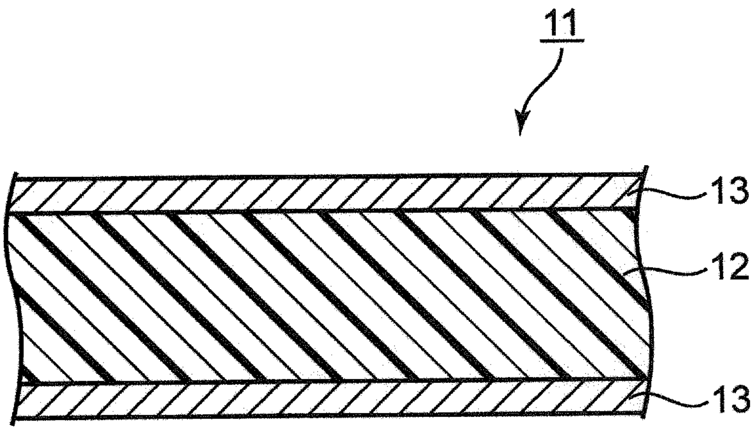

FIG. 3

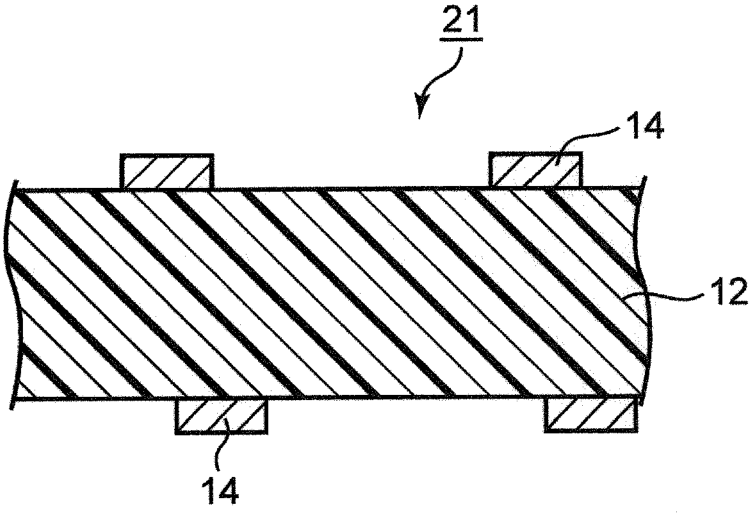

FIG. 4

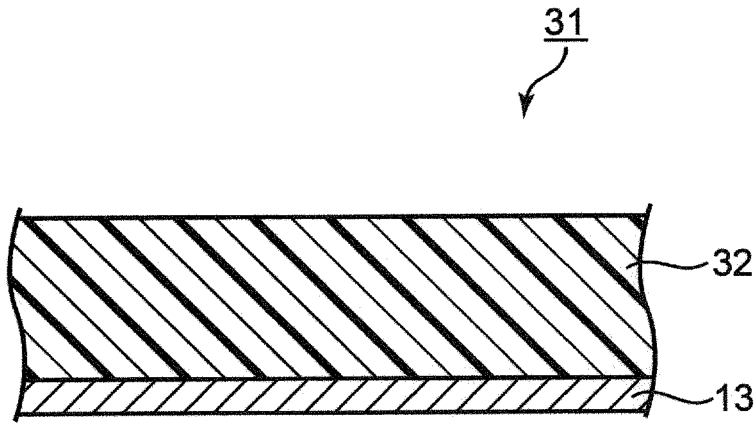

FIG. 5

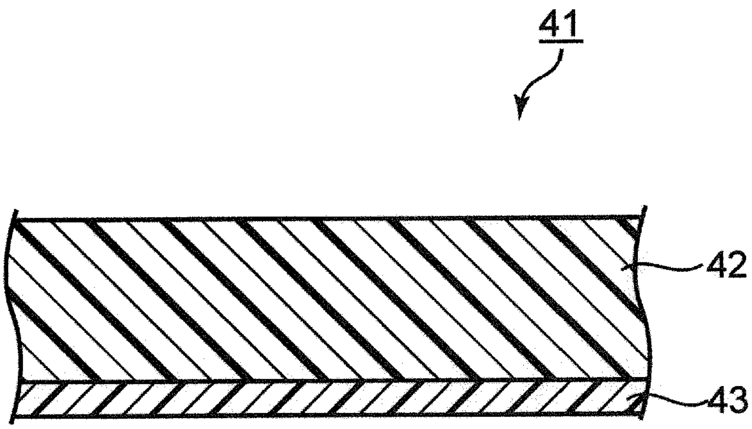

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2009161725 A
- US 2017166729 A1
- JP 2017253159 A